# EUROPEAN PATENT SPECIFICATION

(11) **EP 3 112 413 B1**
(45) Date of publication and mention of the grant of the patent: **15.09.2021**
(21) Application number: 15752805.0
(22) Date of filing: 16.02.2015
(51) Int. Cl.: C08L 23/08, C08J 3/24, C08J 3/28, C09J 7/00

(54) **RADIATION PRE-CROSSLINKED POLYOLEFIN ADHESIVE FILM, PREPARATION METHOD THEREFOR, ENCAPSULATING METHOD AND ASSEMBLY WITH SAME**
STRAHLUNGSVORVERNETZTE POLYOLEFINHAFTFOLIE, HERSTELLUNGSVERFAHREN DAFÜR, VERKAPSELUNGSVERFAHREN UND ANORDNUNG DAMIT
FILM ADHÉSIF DE POLYOLÉFINE PRE-RÉTICULÉE PAR RAYONNEMENT, SON PROCÉDÉ DE PRÉPARATION, PROCÉDÉ D'ENCAPSULATION ET ENSEMBLE L'UTILISANT

(30) Priority: 24.02.2014 CN 201410061030; 24.02.2014 CN 201410061051; 03.03.2014 CN 201420092359 U; 08.01.2015 CN 201510010023
(43) Date of publication of application: 04.01.2017
(73) Proprietor: Shanghai Hiuv New Materials Co., Ltd., Shanghai 201209 (CN)
(72) Inventor: LI, Min, Shanghai 201209 (CN)
(74) Representative: Patentanwälte Olbricht Buchhold Keulertz
(86) International application number: PCT/CN2015/073185
(87) International publication number: WO 2015/124109

(56) References cited:
- WO-A1-2012/082261
- WO-A1-2013/003543
- CN-A- 102 604 557
- CN-A- 102 676 068
- CN-A- 103 013 364
- CN-A- 103 289 582
- CN-A- 103 804 774
- CN-A- 103 819 807
- CN-U- 203 048 857
- CN-U- 203 721 748
- None

## Description

### Technical field

The invention relates to a film and preparation method therefor, and further an application method and module with same, in particular, a polyolefin film for encapsulation field and preparation method therefor, as well as an encapsulation method and module with same.

### Background of the art

Encapsulation technology has been widely used in semiconductor devices, crystalline silicon solar cells wafer, light emitting semiconductor LED, organic light-emitting semiconductor OLED, displays etc. Moreover, encapsulation film layers are needed to adhere to the interior photovoltaic cell to other layers in laminate structures and protect the cell. Encapsulating film is usually made by polyolefin, wherein an ethylene-vinyl acetate (EVA) resin and a polyolefin elastomer are two kind of materials most widely used.

Ethylene - vinyl acetate resin is EVA resin, can be used as the sole material, plastic sheeting and hot melt adhesive. As a kind of hot melt adhesive, the melting point of EVA is low, generally below 90°C, as EVA resin contains high weight percentage of VA (vinyl acetate). As a kind of hot melt adhesive film, EVA resin is made into a stick or a film before use which is convenient for user to operate according to their own process. In the EVA resin, the weight percentage of VA is between 25 and 33wt%, the EVA resin will possess excellent transparency over 90%, and more flexibility. An object of the EVA resin with VA content in that range is ideally suited as a laminated film in double glaze or an encapsulation film for solar module, which can cushion the impact of the glass or protect the very brittle solar cells chip behind the glass in the solar cell module. However, the EVA resin with 25 and 33wt% of VA, has a melting point of 60∼80°C, with a softening point below room temperature, which results in a EVA resin failing to maintaining long-term dimensional stability and physical properties(rigidity) at room temperature. It can only be crosslinked for long term use. For the purpose of crosslinking, it is essential to add thermo-crosslinking agent to said EVA resin film, usually an organic peroxide, such as dicumyl peroxide (DCP), t-butyl peroxy-2-ethylhexyl carbonate (TBEC) etc. Placing the EVA resin film containing thermo-crosslinking agent between the glasses in double glaze, or on both side of the solar cells behind the glass of solar module, vacuuming and heating the packaging component up to 135 °C to fill the gaps between the EVA resin film and the glass or the solar cell by melting EVA resin. At the same time, EVA resin is crosslinked through organic peroxide decomposition. In this case, the crosslinking degree of EVA resin can reach 75-95%. The crosslinked EVA film turns into a kind of thermoset material with flexibility but not melting, which can permanently keep shape and physical properties (rigidity). Usually the EVA film has not been crosslinked before used, the dimensional stability of which is poor, and it is ready to overflows from glass edge after heating and soil the equipment. When laying the colored and transparent EVA film at both up and down side simultaneously, due to poor dimensional stability, the boundary of the colored and the transparent is usually unclear and interpenetrating.

The polyolefin elastomer is POE resin, in particular the copolymers of ethylene and butene, pentene, hexene or octene. It was first invented by Dow, which was copolymerized by octene and ethylene elastomer that possess relatively narrow molecular weight distribution and uniform short-branched chain distribution, with metallocene as catalyst. The crystalline region from ethylene chain in polyolefin elastomer is physical crosslinking site, and butene, pentene, hexene, octene with long chain are in amorphous rubber phase, as a result, the polyolefin elastomer has both elasticity of rubber and thermoplasticity of plastics. The polyolefin elastomer is widely used in processing modified polyolefin such as modified polypropylene used in auto accessories, because it is well compatible with polyolefin especially polyethylene and polypropylene, and has excellent properties of weather resistance and no unsaturated bond simultaneously. The melting temperature of the polyolefin elastomer is low, usually between 50 °C and 70 °C, there is almost no report that polyolefin elastomer is used alone or as the main material both domestically and abroad. The polyolefin elastomer film made from the mixture of polyolefin elastomer and polyethylene compound by Dow, is served as a substitute of conventional EVA film in solar PV modules. The main component, polyolefin elastomer made from the mixture of polyethylene with high melting point and polyolefin elastomer compound with low melting point, so that the peak value of the melting point is above 100 °C. It is known from CN103289582A, the film can be prepared from the polyolefin elastomer by a reactive extrusion grafting step utilizing a graftable alkoxysilane-containing compound followed by adding organic peroxide. When used, the heat-resistance of the polyolefin elastomer is increased through crosslinking reaction initiated by organic peroxide decomposition by heating. Due to very low melting point of the polyolefin elastomer, even under the circumstance of adding polyethylene with high melting point or adding crosslinking agent, the melting point of the polyolefin elastomer is still very low. The elastomer melt quickly during heating which leads to inconvenience, meanwhile, low melting point causes harsh demands of transportation and storage, which limits the use thereof.

Both POE film and EVA film have low melting point. The heating temperature for solar PV module's lamination is usually between 135 °C to 150 °C, which is much higher than both the melting points. Gradually the film melts during the lamination, and it is impossible to maintain moldability and stability. Great changes occur in the film's size and shape before and after lamination. The most obvious example is that the two-layer film, whose size is smaller than glass, overflows surrounding the glass after lamination. Or when one of the two-layer films has color, after lamination, the boundary is unclear and interpenetrating. The above problems have affected the final quality of the components or increased the production process.

It is an important subject to improve the heat-resistant property of encapsulation films such as the EVA film, POE film etc., as hot-melt adhesive in the manufacturing process of encapsulation module, to obtain a clear interface of encapsulation.

Radiation crosslinking is a kind of technique that uses crosslinked reaction between long chain polymers triggered by radiations. Radiation has two categories: one is ionizing radiation, which means that α (alpha), β (beta), γ (gamma), X and neutron rays, that can make a direct or indirect ionization (i. e, atoms or molecules gain or lose electrons and become ions); the other is non-ionizing radiation, such as visible light, ultraviolet light, sound radiation, heat radiation and low-energy electromagnetic radiation and so on. There is lack of binding force between chains of the polymer molecules, making it prone to deformation or damage when subjected to an external force and the ambient temperature, thus restricting its application. Crosslinking reaction results in binding sites such as chemical bonds between the high molecular weight polymer long chains so that the physical and chemical properties of the polymer are improved which is very effective means for polymer modification. During radiation crosslinking, there is no physical contact between the polymer and radiation generator, the shape of the polymer does not change before and after the reaction, but there is internal crosslinking reaction inside the polymer. Polymer product can be directly placed in the radiation for crosslinking reaction; the efficiency of radiation crosslinking can also be promoted by adding crosslinking agent into the polymer. However, non-ionizing radiation such as ultraviolet light has weak penetrability and limited cure depth and moreover light initiator must be used for ultraviolet light curing. Therefore, it's difficult or impossible for partial crosslinking operation for polymer. However, radiation energy sources that can directly trigger polymer crosslinking reactions can be used, such as β-rays, γ-rays, X-rays and etc. it becomes more convenient, and achieves better results for partial crosslinking, since light initiator is not needed.

Radiation crosslinking is widely used in heat-shrinkable tube production. The plastics obtain the shape memory capacity after radiation due to crosslinking, and at room temperature expand the radiated plastic tube making it shrink to its original shape while heated. Another area in which it is commonly used is the production of automotive wire, radiation pre-crosslinked can increase usage temperature of wire that meets the need of higher temperature for vehicle engines.

CN 203 048 857 U discloses a radiation pre-crosslinked polyolefin film suitable for encapsulation, wherein the polyolefin film is an ethylene-vinyl acetate (EVA) resin film and contains 25% VA, and includes organic peroxide crosslinking agents, assistant crosslinking agents, antioxidants, silane coupling agents, polyolefin elastomers (POE), and wherein when the film is all pre-crosslinked, the crosslinking degree of the EVA resin film is 40 %, and the radiation pre-crosslinked EVA resin film has a thickness of 0.4 mm to 0.6 mm.

JP 2001 119 047 A provides a solar cell element sealing material made of an ethylene copolymer irradiated with electron beam. The ethylene copolymer is composed essentially of ethylene and a monomer copolymerizable with ethylene. The monomer includes unsaturated ester, unsaturated carboxylic acid and its metallic salts, unsaturated silicides, and α-olefin. A sheet having a thickness of about 0.1 mm to 1 mm, which is formed of ethylene copolymer, is irradiated with the electron beam at an acceleration voltage set to 150 kV or higher, or more preferably 300 kV or higher for sheets having a thickness of 0.5 mm.

US 6 586 271 B2 describes a method of manufacturing a solar cell module, including the use of low cost polymeric materials with improved mechanical properties. A transparent encapsulant layer is placed adjacent a rear surface of a front support layer. Interconnected solar cells are positioned adjacent a rear surface of the transparent encapsulant layer to form a solar cell assembly. A backskin layer is placed adjacent a rear surface of the solar cell assembly. At least one of the transparent encapsulant layer and the backskin layer are predisposed to electron beam radiation.

JP 2011 074 264 A discloses a resin sealing sheet. In this sheet the resin is softened and stuck thereto. In the resin constituting the resin sealing sheet, an ionizing radiation-crosslinkable resin and a silane coupling agent are contained, wherein the gel fraction of the resin is 1 to 65 mass%.

In CN 101 981 096 A a further sealing resin sheet is disclosed which can be adhered to an object to be sealed when a resin layer therein is soften, whereby the object can be sealed. In the sealing resin sheet, the resin layer comprises an adhesive resin.

### Summary of the invention

In order to overcome the defect of EVA film, POE film and other polyolefin encapsulation film in the encapsulation process of encapsulation module in PV, light emitting semiconductor LED, organic light-emitting semiconductor OLED, displays etc., he present invention has provided a method for producing a radiation pre-crosslinked polyolefin film for encapsulation, comprising following steps:
preparing a film after mixing polyolefin raw materials together, optionally, the step of
▪ preparing the film after mixing the polyolefin raw materials together includes:
▪ using a T-shaped flat mold to extrude for forming the film, or
▪ using two calendar rollers for forming the film;
▪ using a radiation energy source to irradiate the film, wherein the radiation energy source can directly stimulate a crosslinking reaction of the polyolefin raw materials, optionally, the radiation energy source includes one or more of β rays, γ rays, X rays, α rays, and neutron rays;
▪ adjusting an irradiation dosage of the radiation energy source, such that a crosslinking degree of a pre-crosslinked portion of the film reaches 3 % to 95 %, optionally, the step of adjusting the irradiation dosage of the radiation energy source is performed on the film that is laminated or expanded; and;
▪ adjusting the irradiation dosage of the radiaton energy source, such that the pre-corsslinked portion of the film has a thickness of 5 % to 100 % of the film, by a total thickness of the film, wherein: that the pre-crosslinked portion has the thickness of 100 % by the total thickness of the film means the film is all pre-crosslinked;
▪ optionally, the pre-crosslinked portion in the film forms at least one surface layer of the film;.
▪ optionally, a temperature for forming the film is 70 °C to 200 °C, and a mold temperature is 70 °C to 200 °C.

The present invention has provided a method for producing a radiation pre-crosslinked polyolefin film for encapsulation, wherein the pre-crosslinked portion in the film constitutes at least one surface layer of the film.

The present invention has provided a method for producing a radiation pre-crosslinked polyolefin film for encapsulation, characterized in that, said radiation energy source is one of β rays, γ rays, X rays, α rays, or neutron rays.

The present invention has provided a method for producing a radiation pre-crosslinked polyolefin film for encapsulation, characterized in that, the methods for preparing the film after mixing polyolefin raw materials together include, but are not limited to: through T-shaped flat mold for extruding film, or through two calendar rollers for rolling film.

The present invention has provided a method for producing a radiation pre-crosslinked polyolefin film for encapsulation, characterized in that, film formation temperature is 70 to 200 °C, mold temperature is 70 to 200 °C.

The present invention has provided a method for producing a radiation pre-crosslinked polyolefin film for encapsulation, characterized in that, adjusting the radiation energy to irradiate the laminated polyolefin film or the unwound polyolefin film.

The present invention has provided a method for producing a radiation pre-crosslinked polyolefin film for encapsulation, characterized in that, the polyolefin film is ethylene-vinyl acetate resin film.

The present invention has provided a method for producing a radiation pre-crosslinked polyolefin film for encapsulation, characterized in that, the weight parts of ethylene-vinyl acetate resin film are:

| | |
|---|---|
| EVA resing: | 51 to 99.58 parts |
| Organic peroxide crosslinking agents | 0.3 to 2 parts |
| Assistant crosslinking agents | 0.01 to 5 parts |
| Antioxidants | 0.1 to 2 parts |
| Silane coupling agents | 0.01 to 2 parts |
| Pigments | 0 to 40 parts |
| Polyolefin elastomer | 0 to 40 parts |

The present invention has provided a method for producing a radiation pre-crosslinked polyolefin film for encapsulation, characterized in that, the radiation dosage is 0.2 to 100KGY. The present invention has provided a method for producing a radiation pre-crosslinked polyolefin film for encapsulation, characterized in that, pre-crosslinked degree of the ethylene-vinyl acetate resin film is 5% to 74% .

The present invention has provided a method for producing a radiation pre-crosslinked polyolefin film for encapsulation, characterized in that, said radiation pre-crosslinked ethylene-vinyl acetate resin film is a single-layer, double-layers or multi-layers of co-extruded film.

The present invention has provided a method for producing a radiation pre-crosslinked polyolefin film for encapsulation, characterized in that, the thickness of the radiation pre-crosslinked ethylene-vinyl acetate resin film is 0.01 mm to 2 mm; more preferably, the thickness is 0.3 mm to 0.7 mm.

The present invention has provided a method for producing a radiation pre-crosslinked polyolefin film for encapsulation, characterized in that, for said EVA resin, the weight percentage of VA is 20 to 35 wt%, more preferably, the weight percentage is 25 to 33 wt%.

The present invention has provided a method for producing a radiation pre-crosslinked polyolefin film for encapsulation, characterized in that, the organic peroxide as crosslinking agents include, but are not limited to: one or more of the dialkyl peroxides, alkyl aryl peroxides, diaryl peroxides, hydrogen peroxides, diacyl peroxides, peroxy esters, ketone peroxide, peroxycarbonate, peroxy ketals.

The present invention has provided a method for producing a radiation pre-crosslinked polyolefin film for encapsulation, characterized in that, the assistant crosslinking agents include, but are not limited to: one or more of acrylics, methacrylics, acrylamides, allyls, epoxy compounds.

The present invention has provided a method for producing a radiation pre-crosslinked polyolefin film for encapsulation, characterized in that, the antioxidants include, but are not limited to: one or more of the light stabilizers, UV absorbers, and ant-thermal aging decomposition agents.

The present invention has provided a method for producing a radiation pre-crosslinked polyolefin film for encapsulation, characterized in that, the silane coupling agent is an organic silicon compound which contains two groups with different chemical properties.

The present invention has provided a method for producing a radiation pre-crosslinked polyolefin film for encapsulation, characterized in that, the pigments are additives that can change the color of the EVA film including, but are not limited to: one or more of carbon blacks, lithopone, zinc sulfide, titanium dioxide, ultra-fine barium sulfate, glass beads.
The present invention has provided a method for producing a radiation pre-crosslinked polyolefin film for encapsulation, characterized in that, the polyolefin elastomer is carbon-carbon chain resin that can be mixed with EVA, such as at least one of the low-density polyethylene, copolymers of ethylene and butene or octene.
The present invention has provided a method for producing a radiation pre-crosslinked polyolefin film for encapsulation, characterized in that, the polyolefin film is polyolefin elastomer film.

The present invention has provided a method for producing a radiation pre-crosslinked polyolefin film for encapsulation, characterized in that, the weight parts of the polyolefin elastomer film are:

| | |
|---|---|
| Polyolefin elastomer | 69 to 99.8 parts |
| Assistant crosslinking agents | 0.01 to 5 parts |
| Antioxidants | 0.01 to 2 parts |
| Silane coupling agents | 0 to 2 parts |
| Organic peroxide crosslinking agents | 0 to 2 parts |
| Pigments | 0 to 20 parts |

The present invention has provided a method for producing a radiation pre-crosslinked polyolefin film for encapsulation, characterized in that, the radiation dosage is 10 to 200KGY.

The present invention has provided a method for producing a radiation pre-crosslinked polyolefin film for encapsulation, characterized in that, the pre-crosslinked degree of the polyolefin elastomer film is 3% to 70% when radiation pre-crosslinking occurs in all the film.

The present invention has provided a method for producing a radiation pre-crosslinked polyolefin film for encapsulation, characterized in that, the thickness of radiation pre-crosslinked polyolefin elastomer film is 0.2 mm to 1mm; more preferably, the thickness is 0.3 to 0.7mm.

The present invention has provided a method for producing a radiation pre-crosslinked polyolefin film for encapsulation, characterized in that, the polyolefin elastomer is one or more of the copolymers of ethylene with butene, pentene, hexene or octene, or mixture thereof.

The present invention has provided a method for producing a radiation pre-crosslinked polyolefin film for encapsulation, characterized in that, the polyolefin elastomer is with or without polar group grafting, added with small molecule additives of polar group during filming; preferably, the polar group is a silane coupling agent; more preferably, a silane coupling agent in elastomer has been grafted onto the elastomer molecular chain before filming, wherein the grafting ratio is less than 3%; preferably ethylene-hexene copolymer grafted with vinyltrimethoxysilane wherein the grafting rate is 0.6%.

The present invention has provided a method for producing a radiation pre-crosslinked polyolefin film for encapsulation, characterized in that, the assistant crosslinking agent is a monomer with multi-functional groups, including but are not limited to: one or more of triallyl isocyanurate, cyanuric acid triallyl ester, trimethylol propane triacrylate, trimethylol propane trimethacrylate.

The present invention has provided a method for producing a radiation pre-crosslinked polyolefin film for encapsulation, characterized in that, the antioxidant refers to anti-thermal aging decomposition agents and UV absorbers, including, but are not limited to: phenolic antioxidants, hindered amine antioxidants, phosphorous acids, benzophenone, benzotriazoles, for example: not limited to tetra[β-(3,5- di-t-butyl-4-hydroxyphenylyl) propionic acid] pentaerythritol ester, di(2,2,6,6-tetramethyl-4-piperidyl) sebacate and N, N'-di-sec-butyl-p-phenylenediamine.

The present invention has provided a method for producing a radiation pre-crosslinked polyolefin film for encapsulation, characterized in that, the silane coupling agents is an organic silicon compound containing two groups with different chemical properties, preferably KH550.

The present invention has provided a method for producing a radiation pre-crosslinked polyolefin film for encapsulation, characterized in that, the organic peroxide crosslinking agents are thermal crosslinking organic peroxide crosslinking agents, usually used by plastics, including but are not limited to: one or more of dicumyl peroxide, t-butyl peroxy-2-ethylhexyl carbonate, 2,5-dimethyl-2,5-bis (t-butylperoxy) hexyl.

The present invention has provided a method for producing a radiation pre-crosslinked polyolefin film for encapsulating, characterized in that, the pigments are additives that can change the color of EVA film including, but are not limited to carbon blacks , lithopone, zinc sulfide, titanium dioxide, glass microbeads.

The present invention has provided an encapsulation polyolefin film prepared by the radiation pre-crosslinking method, characterized in that, said film has been pre-crosslinked before use so that the size stability and heat resistance of the film is improved, provided that the physical and chemical properties of the film is not changed; when used, the film is subjected to vacuum and heated lamination while still achieve the required 75%-95% crosslinking range. When two or more layers of polyolefin film are required, in particular, transparent and colored polyolefin films are both employed, due to its well size stability and no interpenetration between films, the interface of the encapsulated assemblies is very clear and with good appearance, thus it is suitable for large scale application.

The present invention has provided an encapsulation polyolefin film prepared by the radiation pre-crosslinking method, characterized in that, crosslinking part of the polyolefin film after the radiation of radiation energy source has a 5% to 100% thickness of the polyolefin film, wherein 100% indicates that the film is all crosslinked, and the crosslinking degree of the crosslinking part is 3% to 95%.

The present invention has provided a radiation pre-crosslinked encapsulation polyolefin film, characterized in that, the crosslinking portion in the film forms one surface layer of the film.

The present invention has provided a radiation pre-crosslinked encapsulation polyolefin film, characterized in that, the polyolefin film is ethylene-vinyl acetate resin film.

The present invention has provided a radiation pre-crosslinked encapsulation polyolefin film, characterized in that, the weight parts of the ethylene-vinyl acetate resin film are:

| | |
|---|---|
| EVA resin | 51 to 99.58 parts |
| Organic peroxide crosslinking agents | 0.3 to 2 parts |
| Assistant crosslinking agents | 0.01 to 5 parts |
| Antioxidants | 0.1 to 2 parts |
| Silane coupling agents | 0.01 to 2 parts |
| Pigments | 0 to 40 parts |
| Polyolefin elastomer | 0 to 40 parts |

The present invention has provided a radiation pre-crosslinked encapsulation polyolefin film, characterized in that, pre-crosslinked degree of the radiation pre-crosslinked ethylene-vinyl acetate resin film is 5% to 74%.

The present invention has provided a radiation pre-crosslinked encapsulation polyolefin film, characterized in that, said radiation pre-crosslinked ethylene-vinyl acetate resin film single-layer, double-layers or multi-layers of co-extruded film.

The present invention has provided a radiation pre-crosslinked encapsulation polyolefin film, characterized in that, the thickness of the radiation pre-crosslinked ethylene-vinyl acetate resin film is 0.01mm to 2mm; more preferably, the thickness is 0.3mm to 0.7mm.

The present invention has provided a radiation pre-crosslinked encapsulation polyolefin film, characterized in that, for the ethylene-vinyl acetate resin film, the weight percentage of VA is 20 to 35wt%, more preferably, the weight percentage is 25 to 33wt%.

The present invention has provided a radiation pre-crosslinked encapsulation polyolefin film, characterized in that, the organic peroxide as crosslinking agents include, but are not limited to: one or more of dialkyl peroxides, alkyl aryl peroxides, diaryl peroxides, hydrogen peroxides, diacyl peroxides, peroxy esters, ketone peroxides, peroxycarbonates, peroxy ketals.

The present invention has provided a radiation pre-crosslinked encapsulation polyolefin film, characterized in that, the assistant crosslinking agents include, but are not limited to: one or more of acrylics, methacrylics, acrylamides, allyls, epoxy compounds.

The present invention has provided a radiation pre-crosslinked encapsulation polyolefin film, characterized in that, the antioxidants include, but are not limited to: one or more of light stabilizers, UV absorbers, and anti-thermal oxidative aging decomposition agents.

The present invention has provided a radiation pre-crosslinked encapsulation polyolefin film, characterized in that, the silane coupling agent are organic silicon compounds which contains two groups with different chemical properties.

The present invention has provided a radiation pre-crosslinked encapsulation polyolefin film, characterized in that, the pigments are additives that can change the color of EVA film include, but are not limited to carbon blacks, lithopone, zinc sulfide, titanium dioxide, glass beads.

The present invention has provided an radiation pre-crosslinked encapsulation polyolefin film, characterized in that, the polyolefin elastomer is carbon-carbon chain resin that can be mixed with EVA, such as one or more of the low-density polyethylene, copolymer of ethylene and butene or octene.

The present invention has provided a radiation pre-crosslinked encapsulation polyolefin film, characterized in that, the polyolefin film is also polyolefin elastomer film.

The present invention has provided a radiation pre-crosslinked encapsulation polyolefin film, characterized in that, the weight parts of the polyolefin elastomer film are:

| | |
|---|---|
| Polyolefin elastomer | 69 to 99.8 parts |
| Assistant crosslinking agents | 0.01 to 5 parts |
| Antioxidants | 0.01 to 2 parts |
| Silane coupling agents | 0 to 2 parts |
| Organic peroxide crosslinking agents | 0 to 2 parts |
| Pigments | 0 to 20 parts |

The present invention has provided a radiation pre-crosslinked encapsulation polyolefin film, characterized in that, the pre-crosslinked degree of the polyolefin elastomer film is 3% to 70%.

The present invention has provided a radiation pre-crosslinked encapsulation polyolefin film, characterized in that, the thickness of radiation pre-crosslinked polyolefin elastomer film is 0.2 mm to 1mm; more preferably, the thickness is 0.3 mm to 0.7mm.

The present invention has provided a radiation pre-crosslinked encapsulation polyolefin film, characterized in that, the polyolefin elastomer is one or more of the copolymers of ethylene and butene, pentene, hexene or octene.

The present invention has provided an radiation pre-crosslinked encapsulation polyolefin film, characterized in that, the polyolefin elastomer is polar group with or without grafting, during filming, the small molecular additives with polar groups is added; preferably, the polar group is a silane coupling agent; more preferably, a silane coupling agent in elastomer has been grafted onto the elastomer molecular chain before filming, whose grafting ratio is less than 3%; preferably , grafted Vinyltrimethoxysilane ethylene-hexene copolymer whose grafting rate is 0.6%.

The present invention has provided an radiation pre-crosslinked encapsulation polyolefin film, characterized in that, the assistant crosslinking agent is a monomer with multi-functional groups, including but are not limited to: one or more of triallyl isocyanurate, cyanuric acid triallyl ester, trimethylol propane triacrylate, trimethylol propane trimethacrylate.

The present invention has provided an radiation pre-crosslinked encapsulation polyolefin film, characterized in that, the antioxidants refers to anti-thermal aging decomposition agents and UV absorbers, including, but are not limited to: phenolic antioxidants, hindered amine antioxidants, phosphorous acids, benzophenone, benzotriazoles, for example: not limited to tetra[β-(3,5-di-tert-butyl-4- hydroxyphenyl)propionic acid] pentaerythritol ester, sebacate (2,2,6,6-tetramethyl-4-piperidyl) ester and N, N'- di-sec-butyl-p-phenylenediamine.

The present invention has provided a radiation pre-crosslinked encapsulation polyolefin film, characterized in that, the silane coupling agents are organic silicon compounds containing two groups with different chemical properties, preferably KH550.

The present invention has provided an radiation pre-crosslinked encapsulation polyolefin film, characterized in that, the organic peroxide crosslinking agents are thermal crosslinking organic peroxide crosslinking agents, usually used in plastics, including but are not limited to: one or more of dicumyl peroxide, t-butyl peroxy-2-ethylhexyl carbonate, 2,5-dimethyl-2,5-bis (t-butylperoxy) Hexane.

The present invention has provided a radiation pre-crosslinked encapsulation polyolefin film, characterized in that, the pigments are additives that can change the color of EVA film including, but are not limited to: one or more of carbon blacks, lithopone, zinc sulfide, titanium dioxide, glass beads.

The present invention has provided an encapsulation method using a radiation pre-crosslinked polyolefin film, comprising:
▪ preparing a film after mixing polyolefin raw material together, optionally, the step of preparing the film after mixing the polyolefin raw materials together includes: using a Tshaped flat mold to extrude for forming the film, or using two calendar rollers for forming the film;using a radiation energy source to irradiate the film, wherein the radiation energy source directly stimulate a crosslinking reaction of the polyolefin raw materials;, preferably, the radiation energy source includes one or more of β rays, γ rays, X rays, α rays, and neutron rays;
▪ adjusting an radiation dosage of the radiation energy source, such that a crosslinking degree of a pre-crosslinked of the film reaches 5 % to 9 5%; optionally the irradiation of the radiation energy source is performed on a reel of the polyolefin film or on an expanded polyolefin film;
▪ adjusting the irradiation dosage of the radiation energy source, sucht that the pre-crosslinked portion of the film has a thickness of 5 % to 100 % by a total thickness of the film, wherein 100% means that all the film is all pre-crosslinked;
▪ placing the film between a front protective layer and an encapsulation substrate, and forming an encapsulation assembly with an encapsulated body, wherein the pre-crosslinked portion of the film is in contact with the encapsulated body; and
▪ heating the encapsulation module to further crosslink the film to complete the encapsulation,
▪ optionally, the pre-crosslinked portion in the film includes at least one surface layer of the film,
▪ optionally, a temperature for forming the film is 70 °C to 200 °C, and a mold temperature is 70 °C to 200 °C.

Placing the film between a front protective layer and an encapsulation substrate, and constructing encapsulation module with the encapsulated body, wherein the pre-crosslinked portion of the film is contact with the encapsulated body; Heating the encapsulation module, in order to make further crosslinking reaction occur in the film and thus complete the process of the encapsulation.

The present invention has provided an encapsulation method using radiation pre-crosslinked polyolefin film, characterized in that, the pre-crosslinked portion in the film forms a layer of the film surface.

The present invention has provided an encapsulation method using radiation pre-crosslinked polyolefin film, characterized in that, the radiation energy is the one of β rays, γ rays, X rays, α-rays, or neutron rays.

The present invention has provided an encapsulation method using radiation pre-crosslinked polyolefin film, characterized in that, the methods for preparing the film after mixing polyolefin raw materials together include, but are not limited to: through T-shaped flat mold for extruding film, or through two calendar rollers for rolling film.

The present invention has provided an encapsulation method using radiation pre-crosslinked polyolefin film, characterized in that, film formation temperature is 70 to 200 °C, mold temperature is 70 to 200 °C.

The present invention has provided an encapsulation method using radiation pre-crosslinked polyolefin film, characterized in that, the radiation irradiated the laminated polyolefin film or the unwound polyolefin film.

The present invention has provided an encapsulation method using radiation pre-crosslinked polyolefin film, characterized in that, the polyolefin film is an ethylene-vinyl acetate resin film.

The present invention has provided an encapsulation method using radiation pre-crosslinked polyolefin film, characterized in that, the weight parts of ethylene-vinyl acetate resin film are:

| | |
|---|---|
| EVA resin | 51 to 99.58 parts |
| Organic peroxide crosslinking agents | 0.3 to 2 parts |
| Assistant crosslinking agents | 0.01 to 5 parts |
| Antioxidants | 0.1 to 2 parts |
| Silane coupling agents | 0.01 to 2 parts |
| Pigments | 0 to 40 parts |
| Polyolefin elastomer | 0 to 40 parts |

The present invention has provided an encapsulation method using radiation pre-crosslinked polyolefin film, characterized in that, the radiation dosage is 0.2 to 100KGY.

The present invention has provided an encapsulation method using radiation pre-crosslinked polyolefin film, characterized in that, pre-crosslinked degree of the ethylene-vinyl acetate resin film is 5% to 74% when radiation pre-crosslinking occurs in all the film.

The present invention has provided an encapsulation method using radiation pre-crosslinked polyolefin film according to claim 63, characterized in that, said radiation pre-crosslinked ethylene-vinyl acetate resin film is a single-layer, double-layers or multi-layers of co-extruded film.

The present invention has provided an encapsulation method using radiation pre-crosslinked polyolefin film, characterized in that, the thickness of the radiation pre-crosslinked ethylene-vinyl acetate resin film is 0.01mm to 2mm; more preferably, the thickness is 0.3 mm to 0.7mm.

The present invention has provided an encapsulation method using radiation pre-crosslinked polyolefin film, characterized in that, said polyolefin film is a polyolefin elastomer film.

The present invention has provided an encapsulation method using radiation pre-crosslinked polyolefin film, characterized in that, the weight percentage of said polyolefin elastomer film is:

| | |
|---|---|
| Polyolefin elastomer | 69 to 99.8 parts |
| Assistant crosslinking agents | 0.01 to 5 parts |
| Antioxidants | 0.01 to 2 parts |
| Silane coupling agents | 0 to 2 parts |
| Organic peroxide crosslinking agents | 0 to 2 parts |
| Pigments | 0 to 20 parts |

The present invention has provided an encapsulation method using radiation pre-crosslinked polyolefin film, characterized in that, said radiation dosage is 10 to 200KGY.

The present invention has provided an encapsulation method using radiation pre-crosslinked polyolefin film, characterized in that, pre-crosslinked degree of the polyolefin elastomer film is 3% to 70%when radiation pre-crosslinking occurs in all the film.

The present invention has provided an encapsulation method using radiation pre-crosslinked polyolefin film, characterized in that, the thickness of radiation pre-crosslinked polyolefin elastomer film is 0.2mm to 1mm; more preferably, the thickness is 0.3 to 0.7mm.

The present invention has provided an encapsulation method using radiation pre-crosslinked polyolefin film, characterized in that, the polyolefin elastomer is one or more of the copolymers of ethylene and butene, pentene, hexene or octene.

The present invention has provided an encapsulation method using radiation pre-crosslinked polyolefin film, characterized in that, when the encapsulation module isencapsulated by heating, the encapsulation module could also be encapsulated with pressure or vacuum.

The present invention has provided an encapsulation method using radiation pre-crosslinked polyolefin film, characterized in that, the encapsulated body includes, but are not limited to: crystalline silicon solar cells, light emitting semiconductor LED, organic light emitting semiconductor OLED, display etc.

The present invention has provided an encapsulation method using radiation pre-crosslinked polyolefin film, characterized in that, two layers of film are placed between the front protective layer and the encapsulation substrate, at least one of said films is the pre-crosslinked film, and the encapsulated body is placed between the two layers of said film.

The present invention has provided an encapsulation method using radiation pre-crosslinked polyolefin film, characterized in that, the front protective layer is transparent protective layer, in particular is a transparent glass, transparent ceramics or transparent plastic etc..

The present invention has provided an encapsulation method using radiation pre-crosslinked polyolefin film, characterized in that, the film comprises a layer of EVA (ethylene-vinyl acetate resin) film and a layer of pre-crosslinked EVA film, the EVA film is placed close to the front protective layer.

The present invention has provided an encapsulation method using radiation pre-crosslinked polyolefin film, characterized in that, both of the two layers of film are pre-crosslinked POE (polyolefin elastomer) film.

The present invention has provided an encapsulation method using radiation pre-crosslinked polyolefin film, characterized in that, the encapsulation substrate is glass, ceramic or plastic etc..

The present invention has provided an encapsulation module, characterized in that, the radiation pre-crosslinked polyolefin film is placed between a front protective layer and encapsulation substrate, and constructing encapsulation module with the encapsulated body, wherein the pre-crosslinked portion of the film is in contact with the encapsulated body.

The present invention has provided an encapsulation module, characterized in that, the encapsulated body includes, but are not limited to: crystalline silicon solar cells, light emitting semiconductor LED, an organic light emitting semiconductor OLED, display etc..

The present invention has provided an encapsulation module, characterized in that, placing two layers of film between the front protective layer and the encapsulation substrate, at least one of said films is the pre-crosslinked film, and the encapsulated body is placed between the two layers of said film.

The present invention has provided an encapsulation module, characterized in that, the front protective layer is transparent protective layer, in particular is a transparent glass, transparent ceramics or transparent plastic etc.

The present invention has provided an encapsulation module, characterized in that, the film comprises a layer of EVA (ethylene-vinyl acetate resin) film and a layer of pre-crosslinked EVA film, and the EVA film is placed close to the front protective layer.

The present invention has provided an encapsulation module, characterized in that, both of the two layers of film are pre-crosslinked POE (polyolefin elastomer) film.

The present invention has provided an encapsulation module, characterized in that, the encapsulation substrate is glass, ceramic or plastic etc..

Compared with the prior art, the present invention has the following advantages and beneficial effects:
The present invention provides a pre-crosslinked polyolefin film by high-energy rays. Since crosslinking reaction has occurred in the polyefin film, the dimensional stability and heat-resistance of the film are greatly improved, avoiding the disadvantages of great changes in the dimension and shape due to the heating during encapsulation using non-precrosslinked film, which is advantageous to achieve technical effect of clear interface for the encapsulation module.

### Brief Description of Drawings

FIG1 is an examplary schematic diagram of encapsulation module with radiation pre-crosslinked polyolefin film.
FIG2 is another examplary schematic diagram of encapsulation module with radiation pre-crosslinked polyolefin film.
FIG3 is still another examplary schematic diagram of encapsulation module with radiation pre-crosslinked polyolefin film.

### Detailed Description of Embodiments

The following embodiments are detailed in order that the present invention could be better understood.

### Example 1:

| Components | Weight parts |
|---|---|
| Ethylene-butene copolymer | 99 |
| 3-aminopropyltriethyloxy silane (KH550) | 0.4 |
| triallyl isocyanurate (TAIC) | 0.5 |
| 4 tetra[β-(3,5-di-t-butyl-4-hydroxyphenyl) propionate] pentaerythritol ester (Antioxidants 1010) | 0.1 |

The above-mentioned components are fully mixed and put into the extruder. The temperature of the extruder is 110 °C, and the temperature of the mold is 110 °C; a film is extrude by T-shaped flat mold, or directly formed with two calendar rollers, and then winded. The thickness of the film is 0.3mm, and the length is 100m for a single volume. 3-inch paper core is used to wind the uncrosslinked film.

The entire or multiple volumes of above-mentioned winded uncrosslinked film is unwound and placed under an X-ray generator, the radiation dosage of which is 200KGY. After the radiation, the thickness of the pre-crosslinked film comprises 100% of the total thickness of the film. Measure the degree of crosslinking of the film, which falls into the range of 60% ∼ 70%. Cut off the pre-crosslinked film to the same size of the double-glazing and place it between the double-glazing. get vacuumized and pressurized, and then heat to 200 °C for 10 minutes, and the resulting degree of crosslinking can reach more than 95%. The adhesive force between the pre-crosslinked film and glass is more than 75 N/cm. This pre-crosslinked film overflows the edge of the double-glazing by less than 5 mm.

Two sets of 5 A4-sized films each from the pre-crosslinked film and the uncrosslinked film of the same components respectively are taken, folded and placed into an oven at 35 °C respectively. with weights of 1000g thereon. After 24 hours, the films are taken out to compare the adhesions. It is found that the degree of adhesion of radiation pre-crosslinked film is markedly less than that of the one of the same components without radiation pre-crosslinking.

Two sets of 5 samples of 1cm width and 15cm length each from the pre-crosslinked film and the uncrosslinked film of the same components respectively are taken and compared with respect to the tensile-strength. It is found that the tensile-strength of radiation crosslinked film is higher than that of the one of the same components without radiation pre-crosslinking.

### Example 2:

| Component | Weight parts |
|---|---|
| Ethylene-hexene copolymer grafted by vinyl-trimethoxy- Silane (A-171),grafting 0.6% | 58 |
| Titanium dioxide | 40 |
| TMPTMA | 1 |
| tert-butyl peroxy-2-ethylhexyl carbonate (TBEC) | 0.8 |
| (2,2,6,6- tetramethyl-4-piperidyl) Sebacate (Antioxidant 770) | 0.2 |

The above-mentioned components are well mixed and put into the extruder. The temperature of the extruder is 90 °C, and the temperature of the mold is 90 °C; a film is extruded with T-shaped flat mold, or directly formed with two calendar rollers, and then winded. The thickness of the film is 0.6mm, and the length is 100m for a single volume. 6-inch paper core is used to wind the uncrosslinked film.

The entire or multiple volumes of above-mentioned winded uncrosslinked film are unwound and placed under a β-ray generator, the electronic accelerator energy of which is 10MeV, and the radiation dosage of which is 100KGY. After the radiation, the thickness of the pre-crosslinked film comprises 100% of the total thickness of the film. The degree of crosslinking of the film is measured, which falls into the range of 50%∼70%. Cut off the pre-crosslinked film to the size of the double-glazing and place it between the double-glazing, get vacuumized and pressurized, and then heated to 200 °C for 10 minutes, and the resulting degree of crosslinking can reach more than 95%. The adhesive force of the pre-crosslinked film and glass is more than 75 N / cm.

Two sets of 5 A4-sized samples each from the pre-crosslinked film and the uncrosslinked film of the same components respectively are taken, folded and placed into an oven at 35 °C respectively with weights of 1000g thereon. After 24 hours, the films are taken out to compare the adhesions. It is found that the adhesion of radiated pre-crosslinked film is markedly less than that of the one of the same components without radiation crosslinking.

Two sets of 5 samples of 1cm width and 15cm length each from the pre-crosslinked film and the uncrosslinked film of the same components respectively are taken to compare with respect to the tensile-strength. It is found that the tensile-strength of radiated crosslinked film is higher than that of the one of the same components without radiation crosslinking.

### Example 3:

| Component | Weight parts |
|---|---|
| Ethylene-octene copolymer | 40 |
| Ethylene-hexene copolymer zinc sulfide | 40 16.5 |
| Triallyl isocyanurate (TAIC) | 1 |
| 3-aminopropyl triethoxy silane (silane coupling agent KH550) | 1 |
| Dicumyl peroxide (peroxide crosslinking agent DCP) | 1 |
| N, N'- disuccinic sec-butyl-p-phenylenediamine (Antioxidants 4720) | 0.5 |

The above-mentioned components are fully mixed and put into the extruder, and the temperature of the extruder is 90 °C, and the temperature of the mold is 90 °C; A film is formed by extruding with T-shaped flat mold, or directly formed by two calendar rollers and winded.

The thickness of the film is 0.7mm. The length is 20m for a single volume. 3-inch paper core is used to wind the uncrosslinked film.

The entire or multiple volumes of above-mentioned winded uncrosslinked film is unwound and placed under a β-ray generator, the electronic accelerator energy of which is 5MeV, and the radiation dose of which is 10KGY. After the radiation, the thickness of the pre-crosslinked film comprises 100% of the total thickness of the film. The crosslinking degree of the film is measured and its range is between 3%-9%. Cut off the pre-crosslinked film to the size of the double-glazing and place it between the double-glazing, vacuumize and pressurize, and then heat to 200 °C for 10 minutes. The resulting degree of crosslinking can reach more than 95%. The adhesive force of the pre-crosslinked film and glass is more than 90 N / cm.

Two sets of 5 A4-sized samples each from the pre-crosslinked film and the uncrosslinked film of the same components respectively are taken, folded and placed into an oven at 35 °C respectively with weights of 1000g thereon. After 24 hours, the films are taken out to compare with respect to the adhesions. It is found that the adhesion of radiated pre-crosslinked film is markedly less than that of the one of the same components without radiation crosslinking.

Two sets of 5 samples of 1cm width and 15cm length each from the pre-crosslinked film and the uncrosslinked film of the same components respectively are taken to compare with respect to the tensile-strength. It is found that the tensile-strength of radiated crosslinked film is higher than that of the one of the same components without radiation crosslinking.

### Example 4:

| Component | Weight parts |
|---|---|
| Ethylene-hexene copolymer | 94 |
| 3-aminopropyl triethoxysilane (Silane coupling agent KH550) | 0.4 |
| Titanium dioxide | 5 |
| Triallyl isocyanurate (TAIC) | 0.5 |
| tetra[β-(3,5-di-t-butyl-4-hydroxyphenyl) propionate] pentaerythritol (Antioxidants 1010) | 0.1 |

The above-mentioned components are fully mixed and put into the extruder, and the temperature of the extruder is 110 °C, and the temperature of the mold is 110 °C. A film is formed by extruding with T-shaped flat mold, or directly formed by two calendar rollers and winded. The thickness of the film is 0.6mm, and the length is 400m for a single volume. 3-inch paper core is used to wind the uncrosslinked film.

The above-mentioned winded uncrosslinked film is unwound and placed under a γ-ray generator, then winded with another 3-inch paper core. The radiation dose of the γ-ray is 200KGY. After the radiation, the thickness of the pre-crosslinked film comprises 100% of the total thickness of the film. The crosslinking degree of the film is measured after radiation and its range is between 60%-68%. The above-mentioned pre-crosslinked film is placed to the back of the double glazing solar module cells, with the crosslinked surface placed to the side of the cell, and the uncrosslinked surface placed at the lower layer of the glass and in contact with the glass. The front of the cell is covered with normal transparent polyolefin elastomer film, placed between two pieces of glass with the same size, and then placed all-together into the laminating machine that produces the solar photovoltaic modules. Get vacuumized for 6 minutes , meanwhile heated to 200°C and pressurized for 15 minutes, the resulting degree of crosslinking can reach more than 95%. In the laminate, the pulling force between the pre-crosslinked film and glass is greater than 50 N / cm. The interface between the pre-crosslinked film and the transparent polyolefin elastomer film that is on the side of the battery is clear. For the pre-crosslinked film, the lower film does not migrate to the upper side of the cell.

### Example5:

The formula of EVA film is shown in the table below:

| Component | Weight parts |
|---|---|
| EVA resin, VA content 25% | 51.5 |
| Ethylene - butene copolymer polyolefin elastomer | 40 |
| Titanium dioxide | 5 |
| Trimethylol propane trimethacrylate (TMPTA) | 1 |
| Dicumyl peroxide | 1 |
| tetra[β-(3,5- di-t-butyl-4-hydroxyphenyl) propionate] pentaerythritol (Antioxidants 1010) | 1 |
| Vinyltrimethoxysilane (Silane coupling agent A-171) | 0.5 |

The above components are fully mixed and put into extruder, wherein the temperature of the extruder is 110°C and the temperature of the mold is 110°C. A film is formed by extruding with T-shaped flat mold, or directly formed by two calendar rollers and winded. The thickness of the obtained un-crosslinked EVA film is 0.1mm and the length is 100m for a single volume. 3-inch paper core is used to wind the EVA film.

The winded EVA film is unwound and placed under the β-ray generation device and winded onto another 3-inch paper core. The radiation is by means of electron beam radiation, wherein the accelerator energy is 100keV and the electron beam radiation dosage is 0.2 KGY. The radiation pre-crosslinked film is obtained after radiation. The film thickness of the pre-crosslinked part comprises 50% of the total thickness of the film. The above-mentioned pre-crosslinked EVA film is put on the backside of the cells in the double-glazing photovoltaic module with the crosslinked surface put on the side of the cells, and the uncrosslinked surface at the lower layer glass and in contact with the glass. The front of the cells is covered with regular transparent EVA film. It is placed between two glasses with the same size and is all together put into the laminating machine as a whole for manufacturing the photovoltaic module. It is vacuumized for 6 minutes, heated to 150°C and laminated for 15 minutes. The pulling force between the pre-crosslinked EVA film and the glass is more than 70 N / cm in the laminated product. The interface between the pre-crosslinked EVA film and the transparent EVA film on the upper side of the cells is clear and the phenomenon that the lower pre-crosslinked film transfers to the upper side of the cells does not happen.

### Example 6:

The technical solution of double-layer extruded EVA film is used, wherein one layer of EVA is transparent and the other layer of EVA is black. The formula of two layers of EVA is shown in the table below:

| Transparent EVA layer component | Weight part |
|---|---|
| EVA resin, VA content 33% | 97 |
| Triallyl isocyanurate (TAIC) | 1 |
| 2,5-dimethyl-2,5-bis (tert-butylperoxy) hexane | 0.5 |
| N, N'- disuccinic sec-butyl-p-phenylenediamine (Antioxidants 4720) | 0.5 |
| 2-(2H-benzotriazole-2)-4,6-2(1-methyl-1-phenylethyl) phenol | 0.2 |
| Vinyltrimethoxysilane (Silane coupling agent A-171) | 0.8 |
| Black EVA layer component | Weight part |
| EVA resin, VA content 28% | 92.8 |
| Carbon black | 5 |
| Triallyl isocyanurate (TAIC) | 0.4 |
| 2,5-dimethyl-2,5-bis (tert-butylperoxy) hexane | 0.5 |
| N, N'- disuccinic sec-butyl-p-phenylenediamine (Antioxidants 4720) | 0.5 |
| Vinyltrimethoxysilane (Silane coupling agent A-171) | 0.8 |

The above-mentioned components are fully mixed and put into two barrels of double layer coextruding extruder set (two extruders), the temperature of the extruder is 110°C, and the temperature of distributor is 100°C and the temperature of the mold is 102°C. The mixture which is melted by the extruder enters T-shaped flat mold through the distributor to be extruded into a film, and winded.

The above-mentioned winded EVA film is unwound and placed under a β-ray generator and the side of the transparent layer is towards the radiation generator. After the radiation, 3-inch paper core is used to wind the film. The radiation pre-crosslinked EVA resin co-extruding film is obtained. The EVA film has a film thickness of 0.7mm and the length of the film for a single volume is 300m. The accelerator energy is 500keV and the radiation dosage is 0.2 KGY. The thickness of the pre-crosslinked film part is 100% of the total thickness of the film. The two layers of the pre-crosslinked EVA film are cut off with knife and the crosslinking degree of the transparent layer is measured and the crosslinking degree reaches between 45%-55%. Cut the film into the same size of photovoltaic module. According to the structure of glass/transparent EVA/cells/double-layer co-extruding EVA film/back sheet, it is vacuumized under 148°C and laminated wherein the vacuum time is 5 minutes and the laminating time is 12 minutes. After laminating, the photovoltaic module is obtained, with black back side seeing from glass side and white seeing from back sheet side. The interface between black surface and transparent surface is clear and has no turnover or other appearance defects.

### Example 7:

The formula of EVA film is shown in the table below:

| Component | Weight parts |
|---|---|
| EVA resin, VA content 25% | 60 |
| Ethylene - butene copolymer polyolefin elastomer | 31.5 |
| Titanium dioxide | 5 |
| Trimethylol propane trimethacrylate (TMPTA) | 1 |
| Dicumyl peroxide | 1 |
| tetra[β-(3,5-di-t-butyl-4-hydroxyphenyl) propionate] pentaerythritol (Antioxidants 1010) | 1 |
| Vinyltrimethoxysilane (Silane coupling agent A-171) | 0.5 |

The above-mentioned components are fully mixed and put into extruder. The temperature of the extruder is 110°C and the temperature of the mold is 110°C. A film is formed by extruding with T-shaped flat mold, or directly formed by two calendar rollers and winded. The thickness of the obtained un-crosslinked EVA film is 2mm and the length is 200m for a single volume. 3-inch paper core is used to wind the EVA film.

The above-mentioned winded EVA film is unwound and placed under a β-ray generator, and then winded onto another 3-inch paper core. The radiation is by means of electron beam radiation wherein the accelerator energy is 300keV and the electron beam radiation dosage is 30KGY. The radiation pre-crosslinked film is obtained after radiation. The film thickness of the pre-crosslinked part is 30% of the total thickness of the film. The crosslinking degree of the film is measured and its range is between 25%-35%. Cut the pre-crosslinked film into the same size of of the double-glazing and place it between the double-glazing, get vacuumized and pressurized, and then heated to 200 °C for 10 minutes, The adhesive force between EVA film and glass is larger than 60N/cm. The EVA film overflows the edge of the glass by less than 5mm.

### Example 8:

The formula of EVA film is shown in the table below:

| Components | Weight parts |
|---|---|
| EVA resin, VA content 28% | 78 |
| Ultrafine barium sulfate | 19.5 |
| Cyanuric acid triallyl (TAC) | 0.5 |
| Butylperoxy-2-ethylhexyl carbonate tert-butyl (TBEC) | 1 |
| (2,2,6,6-tetramethyl-4-piperidyl) Sebacate (Antioxidant 770) | 0.5 |
| 3-methacryloxypropyl trimethoxy silane (A-174) | 0.5 |

The above-mentioned components are fully mixed and put into extruder. The temperature of the extruder is 90°C and the temperature of the mold is 90°C. A film is formed by extruding with T-shaped flat mold and winded. The thickness of the obtained un-crosslinked EVA film is 0.1 mm and the length is 20 m for a single volume. 3-inch paper core is used to wind the EVA film.

The entire or multiple volumes of above-mentioned winded EVA film are unwound and placed under a β-ray generator, wherein the accelerator energy is 500keV and the electron beam radiation dose is 100KGY. The film thickness of the pre-crosslinked portion is 100% of the total thickness of the film. The crosslinking degree of the film is measured after radiation and its range is between 53%-74%. Place the above-mentioned pre-crosslinked EVA film to the back of the cells of the photovoltaic module and the front side of the cells is covered with regular transparent EVA film. The solar module cells with the film is placed between two pieces of glass of the same size, and then as a whole placed all-together into the laminating machine that produces the solar photovoltaic modules. Get vacuumized for 6 minutes, meanwhile heated to 150°C and laminated with pressure for 15 minutes. In the laminate, the pulling force between the pre-crosslinked film and glass is greater than 70 N/cm. The interface between the pre-crosslinked EVA film and the transparent EVA film on the upper side of the cells is clear. For the pre-crosslinked film, the lower film does not migrate to the upper film.

### Example 9:

The formula of EVA film is shown in the table below:

| Component | Weight parts |
|---|---|
| EVA resin, VA content 33% | 92.5 |
| Carbon black | 5 |
| Triallyl isocyanurate (TAIC) | 1 |
| 2,5-dimethyl-2,5-bis (tert-butylperoxy) hexane | 0.5 |
| N, N'- disuccinic sec-butyl-p-phenylenediamine (Antioxidants 4720) | 0.5 |
| Vinyltrimethoxysilane (Silane coupling agent A-171) | 0.5 |

The above-mentioned components are fully mixed and put into an extruder. The temperature of the extruder is 100°C and the temperature of the mold is 102°C. A film is formed by extruding with T-shaped flat mold and winded. The thickness of the obtained un-crosslinked EVA film is 0.7 mm and the length is 300m for a single volume. 3-inch paper core is used to wind the EVA film.

The entire or multiple volumes of above-mentioned winded EVA film are unwound and placed under a α-ray generator, where the radiation dosage is 100KGY and the radiation pre-crosslinked film is obtained after radiation. The film thickness of the pre-crosslinked part is 100% of the total thickness of the film. The crosslinking degree of the EVA film is measured and its range is between 35%-55%. Cut the pre-crosslinked EVA film into the size of the double-glazing and place it between the double-glazing, get vacuumized and pressurized, and then heated to 150 °C for 10 minutes and the crosslinking degree reaches 82%-90.

Five layers of the pre-crosslinked EVA film are stacked and placed into an oven at 35 °C, with weights of 1000g thereon for 40 hours. Five layers of the EVA film can be easily separated. The un-pre-crosslinked EVA film of the same formula is seriously stuck together in the same condition.

### Example 10:

The formula of EVA film is shown in the table below:

| Components | Weight parts |
|---|---|
| EVA resin, VA content 28% | 78 |
| Ultrafine barium sulfate | 19.5 |
| Cyanuric acid triallyl (TAC) | 0.5 |
| Butylperoxy-2-ethylhexyl carbonate tert-butyl (TBEC) | 1 |
| Sebacate (2,2,6,6-tetramethyl-4-piperidyl) ester (Antioxidant 770) | 0.5 |
| 3-methacryloxypropyl trimethoxy silane | 0.5 |
| (A-174) | |

The above-mentioned components are fully mixed and put into an extruder. The temperature of the extruder is 90°C. A film is formed by extruding with T-shaped flat mold and winded. The thickness of the obtained EVA film is 0.1 mm. 3-inch paper core is used to wind the EVA film.

The winded EVA film is 100m for a single volume. The winded EVA film is unwound and placed under the α-ray generator, and then winded on another 3-inch paper core. The radiation is by means of α-ray radiation. The radiation dosage is 0.2KGY. After the radiation, the thickness of the pre-crosslinked part is 80% of the total thickness of the film. Since the film is so thin that the surface cannot be removed, The crosslinking degree of the whole is thus measured and the overall crosslinking degree of the EVA film is between 10%-18%. Cut the pre-crosslinked film into the same size of of the double-glazing and place it between the double-glazing. Get vacuumized and pressurized, and then heated to 150 °C for 10 minutes and the crosslinking degree reaches 82%-90. The adhesive force between EVA film and glass is larger than 80N/cm. The EVA film overflows the edge of the double-glazing by less than 2mm.

### Example 11:

The formula of EVA film is shown in the table below:

| Component | Weight parts |
|---|---|
| EVA resin, VA content 25% | 91.5 |
| Titanium dioxide | 5 |
| Trimethylol propane trimethacrylate (TMPTA) | 1 |
| Dicumyl peroxide (DCP) | 1 |
| tetra[β-(3,5-di-t-butyl-4-hydroxyphenyl) propionate] pentaerythritol (Antioxidants | 1 |
| 1010) | |
| Vinyltrimethoxysilane (Silane coupling agent A-171) | 0.5 |

The above-mentioned components are fully mixed and put into an extruder. The temperature of the extruder is 110°C and the temperature of the mold is 110°C. A film is formed by extruding with T-shaped flat mold or directly formed by two calendar rollers and winded. The thickness of the obtained un-crosslinked EVA film is 0.5 mm and the length is 20m for a single volume. 3-inch paper core is used to wind the EVA film.

The winded EVA film is unwound and placed under the X-ray generator, and then winded onto another 3-inch paper core. The radiation is by means of X-ray radiation. The radiation dosage of the X-ray radiation is 0.2KGY. After the radiation, the thickness of the pre-crosslinked portion comprises 40% of the total thickness of the film. The surface of 0.2mm thin is taken to measure the crosslinking degree and the pre-crosslinking degree of the EVA film is between 11%-18%. The above-mentioned pre-crosslinked EVA film is placed to the back of the cells of the photovoltaic module with the crosslinked surface at the cell side and the un-crosslinked surface at the lower glass and in contact with the glass. The front side of the cells is covered with regular transparent EVA film. The solar module cells with the film is placed between two pieces of glass of the same size, and then as a whole placed all-together into the laminating machine that produces the solar photovoltaic modules. Get vacuumized for 6 minutes, meanwhile heated to 150°C and laminated with pressure for 15 minutes. In the laminate, the pulling force between the pre-crosslinked film and glass is greater than 70 N/cm. The interface between the pre-crosslinked EVA film and the transparent EVA film on the upper side of the cells is clear. For the pre-crosslinked film, the lower film does not migrate to the upper film.

### Example 12:

The formula of EVA film is shown in the table below:

| Component | Weight parts |
|---|---|
| EVA resin, VA content 25% | 91.5 |
| Titanium dioxide | 5 |
| Trimethylol propane trimethacrylate (TMPTA) | 1 |
| Dicumyl peroxide (DCP) | 1 |
| tetra[β-(3,5-di-t-butyl-4-hydroxyphenyl) propionate] pentaerythritol (Antioxidants 1010) | 1 |
| Vinyltrimethoxysilane (Silane coupling agent A-171) | 0.5 |

The above-mentioned components are fully mixed and put into an extruder. The temperature of the extruder is 110°C and the temperature of the mold is 110°C. A film is formed by extruding with T-shaped flat mold or directly formed by two calendar rollers and winded. The thickness of the obtained un-crosslinked EVA film is 0.5 mm and the length is 20m for a single volume. 3-inch paper core is used to wind the EVA film.

The winded EVA film is unwound and placed under the γ-ray generator, and then winded onto another 3-inch paper core. The radiation is by means of γ-ray radiation. The radiation dosage of the γ-ray radiation is 0.2KGY. After the radiation, the thickness of the pre-crosslinked portion comprises 50% of the total thickness of the film. The surface of 0.2mm thin is taken to measure the crosslinking degree and the crosslinking degree of the EVA film is between 15%-22%. The above-mentioned pre-crosslinked EVA film is placed to the back of the cells of the photovoltaic module with the crosslinked surface at the cell side and the un-crosslinked surface at the lower glass and in contact with the glass. The front side of the cells is covered with regular transparent EVA film. The solar module cells with the film is placed between two pieces of glass of the same size, and then as a whole placed all-together into the laminating machine that produces the solar photovoltaic modules. Get vacuumized for 6 minutes, meanwhile heated to 150°C and laminated with pressure for 15 minutes. In the laminate, the pulling force between the pre-crosslinked film and glass is greater than 70 N/cm. The interface between the pre-crosslinked EVA film and the transparent EVA film on the upper side of the cells is clear. For the pre-crosslinked film, the lower film does not migrate to the upper film.

### Example 13:

| Component | Weight parts |
|---|---|
| EVA resin, VA content 25% | 93 |
| Titanium dioxide | 5 |
| Trimethylol propane trimethacrylate (TMPTA) | 1 |
| Butylperoxy-2-ethylhexyl carbonate tert-butyl (TBEC) | 0.8 |
| Sebacate (2,2,6,6-tetramethyl-4-piperidyl) ester (Antioxidant 770) | 0.2 |

The above-mentioned components are fully mixed and put into an extruder. The temperature of the extruder is 90°C and the temperature of the mold is 90°C. A film is formed by extruding with T-shaped flat mold or directly formed by two calendar rollers and winded. The thickness of the obtained un-crosslinked EVA film is 0.2 mm and the length is 50m for a single volume. 6-inch paper core is used to wind the EVA film.

The winded EVA film is unwound and placed under the β-ray generator, and then winded onto another 3-inch paper core. The radiation is by means of β-ray radiation. The radiation dosage of the β-ray radiation is 15KGY. After the radiation, the thickness of the pre-crosslinked portion comprises 100% of the total thickness of the film. The crosslinking degree is measured to be between 12%-29%. Cut the pre-crosslinked film into the same size of of the double-glazing and place it between the double-glazing. Get vacuumized and pressurized, and then heated to 150 °C for 10 minutes. The adhesive force between EVA film and glass is larger than 80N/cm.

Two sets of 5 A4-sized samples each from the pre-crosslinked film and the uncrosslinked film of the same components respectively are taken, folded and placed into an oven at 35 °C respectively with weights of 1000g thereon. After 24 hours, the films are taken out to compare with respect to the adhesions. It is found that the adhesion of radiated pre-crosslinked film is markedly less than that of the one of the same components without radiation crosslinking.

Two sets of 5 samples of 1cm width and 15cm length each from the pre-crosslinked film and the uncrosslinked film of the same components respectively are taken to compare with respect to the tensile-strength. It is found that the tensile-strength of radiated crosslinked film is higher than that of the one of the same components without radiation crosslinking.

### Example 14:

| Component | Weight parts |
|---|---|
| EVA resin, VA content 28% | 80 |
| Zinc sulfide | 16.5 |
| Triallyl isocyanurate (TAIC) | 1 |
| 3-aminopropyl triethoxysilane (KH550) | 1 |
| Dicumyl peroxide (DCP) | 1 |
| N, N'- disuccinic sec-butyl-p-phenylenediamine (Antioxidants 4720) | 0.5 |

The above-mentioned components are fully mixed and put into an extruder. The temperature of the extruder is 90°C and the temperature of the mold is 90°C. A film is formed by extruding with T-shaped flat mold or directly formed by two calendar rollers and winded. The thickness of the obtained un-crosslinked EVA film is 0.5 mm and the length is 30m for a single volume. 3-inch paper core is used to wind the EVA film.

The winded EVA film is unwound and placed under the β-ray generator. The radiation is by means of β-ray radiation. The energy of the electron accelerator is 10 MeV. The radiation dosage of the β-ray radiation is 35KGY. After the radiation, the thickness of the pre-crosslinked portion comprises 100% of the total thickness of the film. The crosslinking degree is measured to be between 20%-50%. Cut the pre-crosslinked film into the same size of of the double-glazing and place it between the double-glazing. Get vacuumized and pressurized, and then heated to 155 °C for 10 minutes. The adhesive force between EVA film and glass is larger than 90N/cm.

Two sets of 5 A4-sized samples each from the pre-crosslinked film and the uncrosslinked film of the same components respectively are taken, folded and placed into an oven at 35 °C respectively with weights of 1000g thereon. After 24 hours, the films are taken out to compare with respect to the adhesions. It is found that the adhesion of radiated pre-crosslinked film is markedly less than that of the one of the same components without radiation crosslinking.

Two sets of 5 samples of 1cm width and 15cm length each from the pre-crosslinked film and the uncrosslinked film of the same components respectively are taken to compare with respect to the tensile-strength. It is found that the tensile-strength of radiated crosslinked film is higher than that of the one of the same components without radiation crosslinking.

### Example 15:

| Component | Weight parts |
|---|---|
| Ethylene-hexene copolymer grafted by | 98 |
| vinyl-trimethoxy-silican,grafting 0.6% | |
| TMPTMA | 1 |
| Butylperoxy-2-ethylhexyl carbonate tert-butyl (TBEC) | 0.8 |
| Sebacate (2,2,6,6-tetramethyl-4-piperidyl) ester (Antioxidant 770) | 0.2 |

The above-mentioned components are fully mixed and put into an extruder. The temperature of the extruder is 110°C and the temperature of the mold is 110°C. A film is formed by extruding with T-shaped flat mold or directly formed by two calendar rollers or formed by casting method, and winded. The thickness of the obtained un-crosslinked polyolefin elastomer is 0.01 mm and the length is 20m for a single volume. 6-inch paper core is used to wind the polyolefin elastomer.

The winded EVA film is unwound and placed under the β-ray generator. The radiation is by means of β-ray radiation. The energy of the electron accelerator is 100 MeV. The radiation dosage of the β-ray radiation is 20KGY. After the radiation, the thickness of the pre-crosslinked portion comprises 100% of the total thickness of the film. The crosslinking degree is measured to be between 21%-28%.

Stack the opposite substrate (the glass substrate, a thickness of 150µm) / pre-crosslinked polyolefin elastomer film / organic EL element / substrate (DuPont Teijin Ltd., trade name MelinexS, the thickness of 100µm) in sequence into a laminated body, the crosslinked surface of the pre-crosslinked polyolefin elastomer membrane is placed to the side of organic EL element, the uncrosslinked surface is disposed on the side of opposite substrate in touch with the substrate. The laminate as a whole is then placed in the vacuum laminating machine that produces the EL display, and heated to 100 °C, pressurized for one hour. In the laminate, the drawing force between pre-crosslinked polyolefin elastomer film and the glass substrate is greater than 70 N / cm. The polyolefin elastomer film that overflows the edge of the double-layer substrate is less than 2 mm.

### Example 16:

| Component | Weight parts |
|---|---|
| EVA resin, VA content 25% | 60 |
| Ethylene - butene copolymer polyolefin elastomer | 31.5 |
| Titanium dioxide | 5 |
| Trimethylol propane trimethacrylate (TMPTA) | 1 |
| Dicumyl peroxide | 1 |
| tetra[β-(3,5-di-t-butyl-4-hydroxyphenyl) propionate] pentaerythritol (Antioxidants 1010) | 1 |
| Vinyltrimethoxysilane (Silane coupling agent A-171) | 0.5 |

The above-mentioned components are fully mixed and put into an extruder. The temperature of the extruder is 110°C and the temperature of the mold is 110°C. A film is formed by extruding with T-shaped flat mold, and winded. The thickness of the obtained un-crosslinked EVA film is 2 mm and the length is 200m for a single volume. 3-inch paper core is used to wind the polyolefin elastomer.

The winded EVA film is unwound and placed under the electron beam generator, and then winded onto another 3-inch paper core. The radiation is by means of electron beam radiation. The energy of the accelerator is 200 MeV. The radiation dosage of the electron beam is 30KGY. After the radiation, the thickness of the pre-crosslinked portion comprises 20% of the total thickness of the film. The surface of 0.3mm thin is taken to measure the crosslinking degree and the crosslinking degree of the EVA film is between 20%-35%. The above-mentioned pre-crosslinked EVA film of Example 1 is placed to the back of the cells of the photovoltaic module with the crosslinked surface at the cell side and the un-crosslinked surface at the lower glass and in contact with the glass. The front side of the cells is covered with regular transparent EVA film. The solar module cells with the film is placed between two pieces of glass of the same size, and then as a whole placed all-together into the laminating machine that produces the solar photovoltaic modules. Get vacuumized for 6 minutes, meanwhile heated to 200°C and laminated with pressure for 15 minutes. In the laminate, the pulling force between the pre-crosslinked film and glass is greater than 70 N/cm. The interface between the pre-crosslinked EVA film of Example 1 and the transparent EVA film on the upper side of the cells is clear. For the EVA film of Example 1, the lower film does not migrate to the upper film.

### Example 17:

| Ingredient | Weight |
|---|---|
| EVA resin, VA content of 28% | 78 |
| Ultra-fine barium sulfate (4000 mesh) | 19.5 |
| Cyanuric acid triallyl (TAC) | 0.5 |
| Peroxy-2-ethylhexyl carbonate, t-butyl (TBEC) | 1 |
| Sebacate (2,2,6,6-tetramethyl-4-piperidyl) ester (antioxidant 770) | 0.5 |
| 3- methacryloxy propyl trimethoxysilane (A-174) | 0.5 |

The above-mentioned components are fully mixed and put into an extruder. The temperature of the extruder is 90°C and the temperature of the mold is 90°C. A film is formed by extruding with T-shaped flat mold, and winded. The radiation pre-crosslinked EVA film is obtained after radiation. The thickness of the obtained un-crosslinked EVA film is 0.1 mm. 3-inch paper core is used to wind the EVA film.

The winded EVA film has a length of 100 meters in a single volume. The winded EVA film is unwound and placed under the electron beam generator, and then winded onto another 3-inch paper core. The radiation is by means of electron beam radiation. The energy of the accelerator is 50 MeV. The radiation dosage is 30KGY. After the radiation, the thickness of the pre-crosslinked part is 40% of the total thickness of the film. Since the film is so thin that the surface cannot be removed, The crosslinking degree of the whole is thus measured and the overall crosslinking degree of the EVA film is between 10%-15%. Cut the pre-crosslinked EVA film into the same size of of the double-glazing and place it between the double-glazing. Get vacuumized and pressurized, and then heated to 150 °C for 10 minutes. The adhesive force between EVA film and glass is larger than 80N/cm. The EVA film overflows the edge of the double-glazing by less than 2mm.

### Example 18:

The preferred embodiment of the package module using pre-crosslinked polyolefin film in the present invention is the solar photovoltaic cell component.

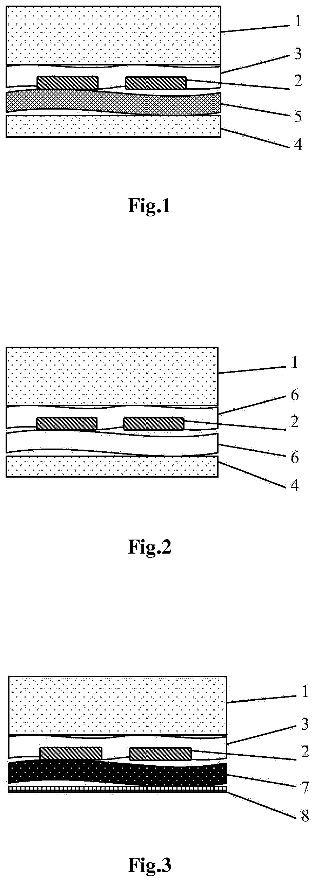

From figure 1 to figure 3, the solar photovoltaic cell module includes a rear portion encapsulation layer of the front glass 1, between the rear portion encapsulation layer of the front glass containing two layers of film, and at least one layer of the film is pre-crosslinked film that is radiated by electron beam, γ-ray, X-ray, an α-ray or neutron ray. The pre-crosslinking degree of the pre-crosslinked film is between 3%∼74%. The thickness of pre-crosslinked film is consistent with the common film of the photovoltaic cells, the thickness is from 0.1 mm to 2 mm. Preferably, the thickness is between 0.3 mm and 0.7 mm.

Compared with not pre-crosslinked film, pre-crosslinked film has already formed a certain crosslinked network before using, so that the heat resistance is greatly improved, the fluidity of resin is reduced, and the melting temperature increases or disappears. During the lamination process of the component manufacturing, the phenomenon that the film overflows around the glass is significantly reduced. If a transparent film and a color film are used at the same time, the interface between the two layers of film is not mutual penetration, and the interface is clear.

The crystalline silicon solar cell 2 or CIGS cells (thin-film solar cells) are set between the layers of the films.

The film comprises a layer of EVA film and a layer of pre-crosslinked EVA film, and the EVA film is set near the front glass. Two layers of film are both pre-crosslinked POE film.

Rear portion encapsulation layer is backplane or rear glass. Backplane or rear glass, not only can be conventional thin photovoltaic modules rear glass or photovoltaic modules backplane, but also can be other material that has the function of support, such as PMMA film (polymethyl methacrylate membrane material, polyamide imide film or sheet, PVC (polyvinyl chloride) profiles, metal sheet and even stone etc..

As shown in Figure 1, the structure of photovoltaic module by Front-to-Rear in turn is: front glass 1, transparent EVA film 3 (not pre-crosslinked, the content of VA is 28%), crystal silicon solar cell 2, White pre-crosslinked EVA film 5 (pre-crosslinking degree of 74%, reflectivity of 88%), rear glass 4. After laminating the structure at 145 °C, the degree of crosslinking between transparent EVA film 3 and the white pre-crosslinked EVA film 5 is greater than 80%. The interface between the transparent EVA film 3 and white pre-crosslinked EVA film 5 is clear, the lower white pre-crosslinked EVA film 5 does not penetrate into the transparent EVA film layer 3, or turn to the crystalline silicon solar cell 2.

As shown in Figure 2, another structure of photovoltaic module by Front-to-Rear in turn is: front glass 1, transparent pre-crosslinked POE film 6 (pre-crosslinking degree of 3%), crystal silicon solar cell 2, transparent pre-crosslinked POE film 6 (pre-crosslinking degree of 15%), rear glass 4. After laminating the structure at 150 °C, the dimensional stability of transparent pre-crosslinked POE film 6 is stable, little film overflows from glass after lamination.

As shown in Figure 3, another structure of photovoltaic module by Front-to-Rear in turn is: front glass 1, transparent EVA film 3, crystal silicon solar cell 2, black pre-crosslinked EVA film 7 (pre-crosslinking degree of 35%), backplate8 (TPE structure back plate). After laminating the structure under 145 °C, the boundary between the transparent EVA film 3 and black pre-crosslinking EVA film 7 is clear, the lower black pre-crosslinked EVA film 7 does not penetrate into the transparent EVA film layer 3, or turn to the crystalline silicon solar cell 2.

The solar photovoltaic modules using the structure, the structure of the photovoltaic modules using the pre-crosslinked film, and its application in solar photovoltaic modules, can achieve the effect of reducing the surrounding overflow of the film. If using the transparent film in the upper layer and colored film in the lower layer, wherein at least one of the films is pre-crosslinked film, two layers of the films do not penetrate to each other, which can remain an effect of clear interface.

## Claims

1. A method for preparing a radiation pre-crosslinked polyolefin film for encapsulation, comprising:
preparing a film after mixing polyolefin raw materials together, optionally, the step of preparing the film after mixing the polyolefin raw materials together includes:
using a T-shaped flat mold to extrude for forming the film, or
using two calendar rollers for forming the film;
using a radiation energy source to irradiate the film, wherein the radiation energy source directly stimulate a crosslinking reaction of the polyolefin raw materials, optionally, the radiation energy source includes one or more of β rays, γ rays, X rays, α rays, and neutron rays;
adjusting an irradiation dosage of the radiation energy source, such that a crosslinking degree of a pre-crosslinked portion of the film reaches 3 % to 95 %, optionally, the step of adjusting the irradiation dosage of the radiation energy source is performed on the film that is laminated or expanded; and
adjusting the irradiation dosage of the radiation energy source, such that the pre-crosslinked portion of the film has a thickness of 5 % to 100 % by a total thickness of the film, wherein: that the pre-crosslinked portion has the thickness of 100 % by the total thickness of the film means the film is all pre-crosslinked;
optionally, the pre-crosslinked portion in the film forms at least one surface layer of the film;
optionally, a temperature for forming the film is 70 °C to 200 °C, and a mold temperature is 70 °C to 200 °C.

2. The method for preparing the radiation pre-crosslinked polyolefin film for encapsulation according to claim 1, wherein:
the film is a polyolefin film including an ethylene-vinyl acetate (EVA) resin film, preferably, wherein the EVA resin film includes:
an EVA resin of 51 parts to 99.58 parts by weight,
organic peroxide crosslinking agents of 0.3 part to 2 parts by weight, preferably, the organic peroxide crosslinking agents include one or more of dialkyl peroxides, alkyl aryl peroxides, diaryl peroxides, hydrogen peroxides, diacyl peroxides, peroxy esters, ketone peroxide, peroxycarbonate, and peroxy ketals,
assistant crosslinking agents of 0.01 part to 5 parts by weight, preferably, the assistant crosslinking agents include one or more of acrylics, methacrylics, acrylamides, allyls, and epoxy compounds,
antioxidants of 0.1 part to 2 parts by weight,
silane coupling agents of 0.01 part to 2 parts by weight,
pigments of 0 part to 40 parts by weight, and
a polyolefin elastomer of 0 part to 40 parts by weight; and
wherein:
the irradiation dosage is 0.2 KGY to 100KGY, and
when the film is all pre-crosslinked, the crosslinking degree of the EVA resin film is 5 % to 74 %;
optionally, the radiation pre-crosslinked EVA resin film includes a single layer, double layers, or multiple layers that are co-extruded, and the radiation pre-crosslinked EVA resin film has a thickness of 0.01 mm to 2 mm.

3. The method for preparing the radiation pre-crosslinked polyolefin film for encapsulation according to claim 1, wherein:
the film includes a polyolefin film including a polyolefin elastomer film, preferably, the polyolefin elastomer film includes:
a polyolefin elastomer of 69 parts to 99.8 parts by weight,
assistant crosslinking agents of 0.01 part to 5 parts by weight, preferably, the assistant crosslinking agent includes one or more of triallyl isocyanurate, cyanuric acid triallyl, trimethylol propane triacrylate, and trimethylol propane trimethacrylate,
antioxidants of 0.01 part to 2 parts by weight,
silane coupling agents of 0 part to 2 parts by weight,
organic peroxide crosslinking agents of 0 part to 2 parts by weight, preferably, the organic peroxide crosslinking agents include one or more of dicumyl peroxide, peroxy-2-ethylhexyl carbonate t-butyl, and 2,5-dimethyl-2,5-bis (t-butylperoxy) hexyl, and
pigments of 0 part to 20 parts by weight,
wherein:
the polyolefin elastomer includes one or more copolymers of ethylene with one or more of butene, pentene, hexene, and octene,
when the film is all pre-crosslinked, the crosslinking degree of the polyolefin elastomer film is 3 % to 70 %, and
the irradiation dosage is 10 KGY to 200 KGY.

4. The radiation pre-crosslinked polyolefin film for encapsulation prepared by the method according to claim 1, wherein:
the crosslinked portion of a polyolefin film formed after the irradiation by the radiation energy source has a thickness of 5 % to 100 % by the total thickness of the polyolefin film,
that the pre-crosslinked portion has the thickness of 100 % by the total thickness of the polyolefin film means the polyolefin film is all pre-crosslinked, and
the pre-crosslinked portion has a crosslinking degree of 3 % to 95 %,
optionally, the crosslinked portion in the polyolefin film is a surface layer of the polyolefin film.

5. The radiation pre-crosslinked polyolefin film for encapsulation according to claim 4, wherein:
the polyolefin film is an ethylene-vinyl acetate (EVA) resin film, preferably, the EVA resin film includes:
an EVA resin of 51 parts to 99.58 parts by weight, preferably, the EVA resin film contains VA of 20 % to 35 % by weight,
organic peroxide crosslinking agents of 0.3 part to 2 parts by weight, preferably, the organic peroxide crosslinking agents include one or more of dialkyl peroxides, alkyl aryl peroxides, diaryl peroxides, hydrogen peroxides, diacyl peroxides, peroxy esters, ketone peroxide, peroxycarbonate, and peroxy ketals,
assistant crosslinking agents of 0.01 part to 5 parts by weight, preferably, the assistant crosslinking agents include one or more of acrylics, methacrylics, acrylamides, allyls, and epoxy compounds,
antioxidants of 0.1 part to 2 parts by weight, preferably, the antioxidants include one or more of light stabilizers, UV absorbers, and thermal oxidative aging decomposers,
silane coupling agents of 0.01 part to 2 parts by weight, preferably, the silane coupling agent includes an organic silicon compound that contains two chemical groups having different chemical properties,
pigments of 0 part to 40 parts by weight, preferably, the pigments are additives capable of changing a color of the EVA resin film, and the pigments include one or more of carbon blacks, lithopone, zinc sulfide, titanium dioxide, and glass beads, and
a polyolefin elastomer of 0 part to 40 parts by weight, optionally, the polyolefin elastomer includes a carbon-carbon chain resin that is mixed with EVA, and the polyolefin elastomer includes one or more of a low-density polyethylene, a copolymer of ethylene and butene, and a copolymer of ethylene and octene; and
wherein: when the film is all pre-crosslinked, the crosslinking degree of the EVA resin film is 5 % to 74 %;
optionally, the radiation pre-crosslinked EVA resin film includes a single layer, double layers, or multiple layers that are co-extruded, and the radiation pre-crosslinked EVA resin film has a thickness of 0.01 mm to 2 mm.

6. The radiation pre-crosslinked polyolefin film for encapsulation according to claim 4, wherein:
the polyolefin film is a polyolefin elastomer film, preferably, the polyolefin elastomer film includes:
a polyolefin elastomer of 69 parts to 99.8 parts by weight,
assistant crosslinking agents of 0.01 part to 5 parts by weight, preferably, the assistant crosslinking agent includes one or more of triallyl isocyanurate, cyanuric acid triallyl, trimethylol propane triacrylate, and trimethylol propane trimethacrylate,
antioxidants of 0.01 part to 2 parts by weight, preferably, the antioxidants include one or more of phenolic antioxidants, hindered amine antioxidants, phosphorous acids, benzophenone, and benzotriazoles including tetra[β-(3,5-di-tert-butyl-4-hydroxyphenyl) propionic acid] pentaerythritol ester, (2,2,6,6-tetramethyl-4-piperidyl) sebacate, N,N'-di-sec-butyl-p-phenylenediamine, and a combination thereof,
silane coupling agents of 0 part to 2 parts by weight, preferably, the silane coupling agent includes an organic silicon compound which contains two chemical groups having different chemical properties,
organic peroxide crosslinking agents of 0 part to 2 parts by weight, preferably, the organic peroxide crosslinking agents include thermal crosslinking organic peroxide crosslinking agents used for plastics, and more preferably, the organic peroxide crosslinking agents include one or more of dicumyl peroxide, t-butyl peroxy-2-ethylhexyl carbonate, and 2,5-dimethyl-2,5-bis (t-butylperoxy) hexane, and
pigments of 0 part to 20 parts by weight, optionally, the pigments are additives capable of changing a color of the EVA resin film, and preferably, the pigments include one or more of carbon blacks, lithopone, zinc sulfide, titanium dioxide, and glass beads, wherein:
the polyolefin elastomer includes one or more copolymers of ethylene with one or more of butene, pentene, hexene, and octene, and
when the film is all pre-crosslinked, the crosslinking degree of the polyolefin elastomer film is 3 % to 70 %.

7. The radiation pre-crosslinked polyolefin film for encapsulation according to claim 6, wherein:
the pre-crosslinked polyolefin elastomer film has a thickness of 0.2 mm to 1 mm.

8. The radiation pre-crosslinked polyolefin film for encapsulation according to claim 6 or 7, wherein:
the polyolefin elastomer is grafted by a polar group, or
the polyolefin elastomer and the polar group are not grafted, and
when forming the film, a small molecule additive with the polar group is added.

9. An encapsulation method of using a radiation pre-crosslinked polyolefin film, comprising:
preparing a film after mixing polyolefin raw materials together, optionally, the step of preparing the film after mixing the polyolefin raw materials together includes: using a T-shaped flat mold to extrude for forming the film, or using two calendar rollers for forming the film;
using a radiation energy source to irradiate the film, wherein the radiation energy source directly stimulate a crosslinking reaction of the polyolefin raw materials, preferably, the radiation energy source includes one or more of β rays, γ rays, X rays, α rays, and neutron rays;
adjusting an irradiation dosage of the radiation energy source, such that a crosslinking degree of a pre-crosslinked portion of the film reaches 5 % to 95 %, optionally, the irradiation of the radiation energy source is performed on a reel of the polyolefin film or on an expanded polyolefin film;
adjusting the irradiation dosage of the radiation energy source, such that the pre-crosslinked portion of the film has a thickness of 5 % to 100 % by a total thickness of the film, wherein 100 % means the film is all pre-crosslinked,
placing the film between a front protective layer and an encapsulation substrate, and forming an encapsulation assembly with an encapsulated body, wherein the pre-crosslinked portion of the film is in contact with the encapsulated body; and
heating the encapsulation module to further crosslink the film to complete the encapsulation,
optionally, the pre-crosslinked portion in the film includes at least one surface layer of the film,
optionally, a temperature for forming the film is 70 °C to 200 °C, and a mold temperature is 70 °C to 200 °C.

10. An encapsulation module formed by the encapsulation method of using the radiation pre-crosslinked polyolefin film according to claim 9, wherein:
the radiation pre-crosslinked polyolefin film is placed between the front protective layer and the encapsulation substrate and constitutes the encapsulation module together with the encapsulated body, preferably, the encapsulation substrate is glass, ceramic, or plastic,
the pre-crosslinked portion of the polyolefin film is in contact with the encapsulated body.

11. The encapsulation module according to claim 10, wherein:
the encapsulated body includes one or more of a crystalline silicon solar cell, a light emitting diode (LED), an organic light emitting diode (OLED), and a display device.

12. The encapsulation module according to claim 10, wherein:
the film includes two layers placed between the front protective layer and the encapsulation substrate,
at least one of the two layers is the pre-crosslinked film, and
the encapsulated body is placed between the two layers.

13. The encapsulation module according to claim 10, wherein:
the front protective layer is a transparent protective layer including a transparent glass, a transparent ceramics, or a transparent plastic.

14. The encapsulation module according to claim 10, wherein:
the film includes a layer of ethylene-vinyl acetate (EVA) film and a layer of pre-crosslinked EVA film, and
the layer of the EVA film is placed adjacent to the front protective layer.

15. The encapsulation module according to claim 12, wherein each of the two layers is a pre-crosslinked polyolefin elastomer (POE) film.

## Patentansprüche

1. Verfahren zur Herstellung einer strahlungsvorvernetzten Polyolefinfolie zur Einkapselung, umfassend:
Herstellen einer Folie nach dem Zusammenmischen der Polyolefin-Rohmaterialien, optional umfasst der Schritt des Herstellens der Folie nach dem Zusammenmischen der Polyolefin-Rohmaterialien:
Verwenden einer T-förmigen flachen Form zum Extrudieren zur Bildung der Folie oder
Verwenden von zwei Kalanderwalzen zum Bilden des Films;
Verwenden einer Strahlungsenergiequelle zum Bestrahlen des Films, wobei die Strahlungsenergiequelle direkt eine Vernetzungsreaktion der Polyolefin-Rohmaterialien stimuliert, optional umfasst die Strahlungsenergiequelle eine oder mehrere von β-Strahlen, γ-Strahlen, Röntgenstrahlen, α-Strahlen und Neutronenstrahlen;
Einstellen einer Bestrahlungsdosis der Strahlungsenergiequelle, so dass ein Vernetzungsgrad eines vorvernetzten Teils des Films 3 % bis 95 % erreicht, optional wird der Schritt des Einstellens der Bestrahlungsdosis der Strahlungsenergiequelle an dem Film durchgeführt das laminiert oder expandiert ist; und
Einstellen der Bestrahlungsdosis der Strahlungsenergiequelle, so dass der vorvernetzte Abschnitt des Films eine Dicke von 5 % bis 100 % der Gesamtdicke des Films aufweist, wobei: dass der vorvernetzte Abschnitt eine Dicke von 100 . aufweist % bezogen auf die Gesamtdicke der Folie bedeutet, dass die Folie vollständig vorvernetzt ist;
optional bildet der vorvernetzte Teil in der Folie mindestens eine Oberflächenschicht der Folie;
optional beträgt eine Temperatur zum Bilden des Films 70°C bis 200°C und eine Formtemperatur beträgt 70°C bis 200°C.

2. Verfahren zur Herstellung der strahlungsvorvernetzten Polyolefinfolie zur Einkapselung nach Anspruch 1, wobei:
der Film ein Polyolefinfilm ist, der einen Ethylen-Vinylacetat (EVA)-Harzfilm umfasst, vorzugsweise, wobei der EVA-Harzfilm umfasst:
ein EVA-Harz von 51 bis 99,58 Gewichtsteilen,
organische Peroxid-Vernetzungsmittel von 0,3 Gewichtsteilen bis 2 Gewichtsteilen, vorzugsweise umfassen die organischen Peroxid-Vernetzungsmittel eines oder mehrere von Dialkylperoxiden, Alkylarylperoxiden, Diarylperoxiden, Wasserstoffperoxiden, Diacylperoxiden, Peroxyestern, Ketonperoxid, Peroxycarbonat und Peroxyketale,
Hilfsvernetzungsmittel von 0,01 bis 5 Gewichtsteilen, vorzugsweise umfassen die Hilfsvernetzungsmittel eines oder mehrere von Acrylen, Methacrylen, Acrylamiden, Allylen und Epoxyverbindungen.
Antioxidantien von 0,1 bis 2 Gewichtsteilen,
Silan-Haftvermittler von 0,01 bis 2 Gewichtsteilen,
Pigmente von 0 bis 40 Gewichtsteilen und
ein Polyolefin-Elastomer von 0 bis 40 Gewichtsteilen; und
worin:
die Bestrahlungsdosis beträgt 0,2 KGY bis 100KGY, und
wenn der Film vollständig vorvernetzt ist, beträgt der Vernetzungsgrad des EVA-Harzfilms 5 % bis 74 %;
optional umfasst der strahlungsvorvernetzte EVA-Harzfilm eine Einzelschicht, Doppelschichten oder mehrere Schichten, die coextrudiert werden, und der strahlungsvorvernetzte EVA-Harzfilm weist eine Dicke von 0,01 mm bis 2 mm auf.

3. Verfahren zur Herstellung der strahlungsvorvernetzten Polyolefinfolie zur Einkapselung nach Anspruch 1, wobei:
der Film umfasst einen Polyolefinfilm, der einen Polyolefin-Elastomerfilm umfasst, vorzugsweise umfasst der Polyolefin-Elastomerfilm:
ein Polyolefin-Elastomer von 69 bis 99,8 Gewichtsteilen,
Hilfsvernetzungsmittel von 0,01 bis 5 Gewichtsteilen, vorzugsweise umfasst das Hilfsvernetzungsmittel eines oder mehrere von Triallylisocyanurat, Cyanursäuretriallyl, Trimethylolpropantriacrylat und
Trimethylolpropantrimethacrylat,
Antioxidantien von 0,01 bis 2 Gewichtsteilen,
Silan-Haftvermittler von 0 bis 2 Gewichtsteilen,
organische Peroxid-Vernetzungsmittel von 0 bis 2 Gewichtsteilen, vorzugsweise umfassen die organischen Peroxid-Vernetzungsmittel eines oder mehrere von Dicumylperoxid, Peroxy-2-ethylhexylcarbonat-t-butyl und 2,5-Dimethyl-2,5-bis (t-Butylperoxy)hexyl und
Pigmente von 0 bis 20 Gewichtsteilen,
worin:
das Polyolefin-Elastomer ein oder mehrere Copolymere von Ethylen mit einem oder mehreren von Buten, Penten, Hexan und Oktan umfasst,
wenn die Folie vollständig vorvernetzt ist, beträgt der Vernetzungsgrad der Polyolefin-Elastomerfolie 3 % bis 70 %, und
die Bestrahlungsdosis beträgt 10 KGY bis 200 KGY.

4. Strahlungsvorvernetzte Polyolefinfolie zur Einkapselung, hergestellt nach dem Verfahren nach Anspruch 1, wobei:
der vernetzte Teil eines Polyolefinfilms, der nach der Bestrahlung durch die Strahlungsenergiequelle gebildet wurde, eine Dicke von 5 % bis 100 % der Gesamtdicke des Polyolefinfilms aufweist,
dass der vorvernetzte Teil eine Dicke von 100 % der Gesamtdicke der Polyolefinfolie aufweist, bedeutet, dass die Polyolefinfolie vollständig vorvernetzt ist, und
der vorvernetzte Anteil einen Vernetzungsgrad von 3 % bis 95 % aufweist,
optional ist der vernetzte Teil in der Polyolefinfolie eine Oberflächenschicht der Polyolefinfolie.

5. Strahlungsvorvernetzter Polyolefinfilm zur Einkapselung nach Anspruch 4, wobei:
der Polyolefinfilm ist ein Ethylen-Vinylacetat (EVA)-Harzfilm, vorzugsweise umfasst der EVA-Harzfilm:
ein EVA-Harz von 51 bis 99,58 Gewichtsteilen, vorzugsweise enthält der EVA-Harzfilm VA von 20 bis 35 Gewichts-%,
organische Peroxid-Vernetzungsmittel von 0,3 Gewichtsteilen bis 2 Gewichtsteilen, vorzugsweise umfassen die organischen Peroxid-Vernetzungsmittel eines oder mehrere von Dialkylperoxiden, Alkylarylperoxiden, Diarylperoxiden, Wasserstoffperoxiden, Diacylperoxiden, Peroxyestern, Ketonperoxid, Peroxycarbonat und Peroxyketale,
Hilfsvernetzungsmittel von 0,01 bis 5 Gewichtsteilen, vorzugsweise umfassen die Hilfsvernetzungsmittel eines oder mehrere von Acrylen, Methacrylen, Acrylamiden, Allylen und Epoxyverbindungen.
Antioxidantien von 0,1 bis 2 Gewichtsteilen, vorzugsweise umfassen die Antioxidantien einen oder mehrere von Lichtstabilisatoren, UV-Absorbern und Zersetzungsmitteln durch thermische oxidative Alterung,
Silan-Haftvermittler von 0,01 bis 2 Gewichtsteilen, vorzugsweise umfasst der Silan-Haftvermittler eine organische Siliziumverbindung, die zwei chemische Gruppen mit unterschiedlichen chemischen Eigenschaften enthält,
Pigmente von 0 bis 40 Gewichtsteilen, vorzugsweise sind die Pigmente Additive, die die Farbe des EVA-Harzfilms ändern können, und die Pigmente umfassen einen oder mehrere von Rußen, Lithopon, Zinksulfid, Titandioxid und Glasperlen, und
ein Polyolefinelastomer von 0 bis 40 Gewichtsteilen, optional umfasst das Polyolefinelastomer ein Kohlenstoff-Kohlenstoff-Kettenharz, das mit EVA gemischt ist, und das Polyolefinelastomer umfasst eines oder mehrere von einem Polyethylen niedriger Dichte, einem Copolymer von Ethylen und Butan und ein Copolymer von Ethylen und Octan; und
wobei: wenn der Film vollständig vorvernetzt ist, der Vernetzungsgrad des EVA-Harzfilms 5 % bis 74 % beträgt;
optional umfasst der strahlungsvorvernetzte EVA-Harzfilm eine Einzelschicht, Doppelschichten oder mehrere Schichten, die coextrudiert werden, und der strahlungsvorvernetzte EVA-Harzfilm weist eine Dicke von 0,01 mm bis 2 mm auf.

6. Strahlungsvorvernetzter Polyolefinfilm zur Einkapselung nach Anspruch 4, wobei:
der Polyolefinfilm ist ein Polyolefin-Elastomerfilm, vorzugsweise umfasst der Polyolefin-Elastomerfilm:
ein Polyolefin-Elastomer von 69 bis 99,8 Gewichtsteilen,
Hilfsvernetzungsmittel von 0,01 bis 5 Gewichtsteilen, vorzugsweise umfasst das Hilfsvernetzungsmittel eines oder mehrere von Triallylisocyanurat, Cyanursäuretriallyl, Trimethylolpropantriacrylat und Trimethylolpropantrimethacrylat,
Antioxidantien von 0,01 bis 2 Gewichtsteilen, vorzugsweise umfassen die Antioxidantien eines oder mehrere von phenolischen Antioxidantien, gehinderten Amin-Antioxidantien, phosphorigen Säuren, Benzophenon und Benzotriazolen, einschließlich Tetra[β-(3,5-di-tert-butyl-4.). -Hydroxyphenyl)propionsäure]pentaerythritolester,
(2,2,6,6-Tetramethyl-4-piperidyl)sebacat, N,N'-Di-sec-butyl-p-phenylendiamin und eine Kombination davon,
Silan-Haftvermittler von 0 bis 2 Gewichtsteilen, vorzugsweise umfasst der Silan-Haftvermittler eine organische Siliziumverbindung, die zwei chemische Gruppen mit unterschiedlichen chemischen Eigenschaften enthält,
organische Peroxid-Vernetzungsmittel von 0 bis 2 Gewichtsteilen, vorzugsweise umfassen die organischen Peroxid-Vernetzungsmittel thermisch vernetzende organische Peroxid-Vernetzungsmittel, die für Kunststoffe verwendet werden, und stärker bevorzugt umfassen die organischen Peroxid-Vernetzungsmittel eines oder mehrere von Dicumylperoxid, t- Butylperoxy-2-ethylhexylcarbonat und 2,5-Dimethyl-2,5-bis(t-butylperoxy)hexan und
Pigmente von 0 bis 20 Gewichtsteilen, optional sind die Pigmente Additive, die die Farbe des EVA-Harzfilms ändern können, und vorzugsweise umfassen die Pigmente einen oder mehrere von Rußen, Lithopon, Zinksulfid, Titandioxid und Glas Perlen,
worin:
das Polyolefin-Elastomer ein oder mehrere Copolymere von Ethylen mit einem oder mehreren von Buten, Penten, Hexan und Octan umfasst, und
wenn die Folie vollständig vorvernetzt ist, beträgt der Vernetzungsgrad der Polyolefin-Elastomerfolie 3 % bis 70 %.

7. Strahlungsvorvernetzter Polyolefinfilm zur Einkapselung nach Anspruch 6, wobei: die vorvernetzte Polyolefin-Elastomerfolie hat eine Dicke von 0,2 mm bis 1 mm.

8. Strahlungsvorvernetzte Polyolefinfolie zur Einkapselung nach Anspruch 6 oder 7, wobei:
das Polyolefinelastomer mit einer polaren Gruppe gepfropft ist oder
das Polyolefinelastomer und die polare Gruppe sind nicht gepfropft und
bei der Bildung des Films wird ein niedermolekulares Additiv mit der polaren Gruppe hinzugefügt.

9. Einkapselungsverfahren zur Verwendung einer durch Strahlung vorvernetzten Polyolefinfolie, umfassend:
Herstellen einer Folie nach dem Zusammenmischen von Polyolefin-Rohmaterialien, optional umfasst der Schritt des Herstellens der Folie nach dem Zusammenmischen der Polyolefin-Rohmaterialien: Verwenden einer T-förmigen flachen Form zum Extrudieren zum Bilden des Films oder Verwenden von zwei Kalanderwalzen zum Bilden des Films ;
Verwenden einer Strahlungsenergiequelle zum Bestrahlen des Films, wobei die Strahlungsenergiequelle direkt eine Vernetzungsreaktion der Polyolefin-Rohmaterialien stimuliert, vorzugsweise umfasst die Strahlungsenergiequelle eine oder mehrere von β-Strahlen, γ-Strahlen, Röntgenstrahlen, α-Strahlen und Neutronenstrahlen;
Einstellen einer Bestrahlungsdosis der Strahlungsenergiequelle, so dass ein Vernetzungsgrad eines vorvernetzten Teils der Folie 3 % bis 95 % erreicht, optional wird die Bestrahlung der Strahlungsenergiequelle auf einer Rolle der Polyolefinfolie durchgeführt oder auf einem expandierten Polyolefinfilm;
Einstellen der Bestrahlungsdosis der Strahlungsenergiequelle, so dass der vorvernetzte Abschnitt des Films eine Dicke von 5 % bis 100 % der Gesamtdicke des Films aufweist, wobei: dass der vorvernetzte Abschnitt eine Dicke von 100 . aufweist % bezogen auf die Gesamtdicke der Folie bedeutet, dass die Folie vollständig vorvernetzt ist,
Anordnen des Films zwischen einer vorderen Schutzschicht und einem Einkapselungssubstrat und Bilden einer Einkapselungsanordnung mit einem eingekapselten Körper, wobei der vorvernetzte Abschnitt des Films in Kontakt mit dem eingekapselten Körper ist; und
Erhitzen des Einkapselungsmoduls, um den Film weiter zu vernetzen, um die Einkapselung zu vervollständigen,
optional beinhaltet der vorvernetzte Abschnitt in der Folie mindestens eine Oberflächenschicht der Folie,
optional beträgt eine Temperatur zum Bilden des Films 70°C bis 200°C und eine Formtemperatur beträgt 70°C bis 200°C.

10. Einkapselungsmodul, gebildet durch das Einkapselungsverfahren unter Verwendung der strahlungsvorvernetzten Polyolefinfolie nach Anspruch 9, wobei:
die Polyolefinfolie wird zwischen der vorderen Schutzschicht und dem Einkapselungssubstrat platziert, vorzugsweise ist das Einkapselungssubstrat Glas, Keramik oder Kunststoff,
die Polyolefinfolie und der gekapselte Körper sind im Kapselungsmodul enthalten und
der vorvernetzte Teil der Polyolefinfolie steht mit dem eingekapselten Körper in Kontakt.

11. Kapselungsmodul nach Anspruch 10, wobei:
der eingekapselte Körper eine oder mehrere von einer kristallinen Siliziumsolarzelle, einer Leuchtdiode (LED), einer organischen Leuchtdiode (OLED) und einer Anzeigevorrichtung umfasst.

12. Kapselungsmodul nach Anspruch 10, wobei:
die Folie enthält zwei Schichten, die zwischen der vorderen Schutzschicht und dem Verkapselungssubstrat angeordnet sind,
mindestens eine der beiden Schichten der vorvernetzte Film ist, und
der gekapselte Körper wird zwischen die beiden Schichten gelegt.

13. Kapselungsmodul nach Anspruch 10, wobei:
die vordere Schutzschicht ist eine transparente Schutzschicht, die ein transparentes Glas, eine transparente Keramik oder einen transparenten Kunststoff umfasst.

14. Verkapselungsmodul nach Anspruch 10, wobei:
die Folie enthält eine Schicht aus Ethylen-Vinylacetat (EVA)-Folie und eine Schicht aus vorvernetzter EVA-Folie, und
die Schicht der EVA-Folie wird neben der vorderen Schutzschicht platziert.

15. Verkapselungsmodul nach Anspruch 12, wobei jede der beiden Schichten eine vorvernetzte Polyolefin-Elastomer (POE)-Folie ist.

## Revendications

1. Procédé de préparation d'un film de polyoléfine pré-réticulé par rayonnement pour encapsulation, comprenant:
préparation d'un film après mélange des matières premières polyoléfiniques ensemble, facultativement, l'étape de préparation du film après mélange des matières premières polyoléfiniques ensemble comprend :
en utilisant un moule plat en forme de T à extruder pour former le film, ou
utiliser deux rouleaux de calandre pour former le film ;
utiliser une source d'énergie de rayonnement pour irradier le film, dans lequel la source d'énergie de rayonnement stimule directement une réaction de réticulation des matières premières polyoléfiniques, facultativement, la source d'énergie de rayonnement comprend un ou plusieurs des rayons β, des rayons y, des rayons X, des rayons a, et rayons neutroniques;
ajuster un dosage d'irradiation de la source d'énergie de rayonnement, de telle sorte qu'un degré de réticulation d'une partie pré-réticulée du film atteigne 3 % à 95 %, facultativement, l'étape d'ajustement du dosage d'irradiation de la source d'énergie de rayonnement est effectuée sur le film qui est laminé ou expansé ; et
ajuster le dosage d'irradiation de la source d'énergie de rayonnement, de telle sorte que la partie pré-réticulée du film a une épaisseur de 5 % à 100 % par une épaisseur totale du film, dans lequel : la partie pré-réticulée a une épaisseur de 100 % de l'épaisseur totale du film signifie que le film est entièrement pré-réticulé;
éventuellement, la partie pré-réticulée dans le film forme au moins une couche superficielle du film ;
facultativement, une température pour former le film est de 70 °C à 200 °C, et une température de moule est de 70 °C à 200 °C.

2. Procédé de préparation du film de polyoléfine préréticulée par rayonnement pour encapsulation selon la revendication 1, dans lequel:
le film est un film de polyoléfine comprenant un film de résine éthylène-acétate de vinyle (EVA), de préférence, le film de résine EVA comprenant :
une résine EVA de 51 parties à 99,58 parties en poids,
des agents de réticulation de peroxyde organique de 0,3 partie à 2 parties en poids, de préférence, les agents de réticulation de peroxyde organique comprennent un ou plusieurs peroxydes de dialkyle, peroxydes d'alkylaryle, peroxydes de diaryle, peroxydes d'hydrogène, peroxydes de diacyl, peroxyesters, peroxyde de cétone, peroxycarbonate, et peroxycétals,
des agents de réticulation auxiliaires de 0,01 partie à 5 parties en poids, de préférence, les agents de réticulation auxiliaires comprennent un ou plusieurs des composés acryliques, méthacryliques, acrylamides, allyles et époxy,
des antioxydants de 0,1 partie à 2 parties en poids,
des agents de couplage au silane de 0,01 partie à 2 parties en poids,
des pigments de 0 partie à 40 parties en poids, et
un élastomère polyoléfinique de 0 partie à 40 parties en poids ; et
où:
le dosage d'irradiation est de 0,2 KGY à 100KGY, et
lorsque le film est entièrement pré-réticulé, le degré de réticulation du film de résine EVA est de 5 % à 74 % ;
facultativement, le film de résine EVA pré-réticulé par rayonnement comprend une couche unique, des doubles couches ou des couches multiples qui sont co-extrudées, et le film de résine EVA pré-réticulé par rayonnement a une épaisseur de 0,01 mm à 2 mm.

3. Procédé de préparation du film de polyoléfine préréticulée par rayonnement pour encapsulation selon la revendication 1, **caractérisé en ce que** :
le film comprend un film de polyoléfine comprenant un film d'élastomère de polyoléfine, de préférence, le film d'élastomère de polyoléfine comprend :
un élastomère polyoléfinique de 69 parties à 99,8 parties en poids,
des agents de réticulation auxiliaires de 0,01 partie à 5 parties en poids, de préférence, l'agent de réticulation auxiliaire comprend un ou plusieurs parmi l'isocyanurate de triallyle, le triallyle d'acide cyanurique, le triacrylate de triméthylol propane et le triméthacrylate de triméthylol propane,
des antioxydants de 0,01 partie à 2 parties en poids,
des agents de couplage au silane de 0 partie à 2 parties en poids,
agents de réticulation peroxyde organique de 0 partie à 2 parties en poids, de préférence, les agents de réticulation peroxyde organique comprennent un ou plusieurs de peroxyde de dicumyle, peroxy-2-éthylhexyl carbonate de t-butyle, et 2,5-diméthyl-2,5-bis (t-butylperoxy) hexyle, et
pigments de 0 partie à 20 parties en poids,
où:
l'élastomère polyoléfinique comprend un ou plusieurs copolymères d'éthylène avec un ou plusieurs parmi le butène, le pentène, l'hexane et l'octane,
lorsque le film est entièrement pré-réticulé, le degré de réticulation du film élastomère de polyoléfine est de 3 % à 70 %, et
le dosage d'irradiation est de 10 KGY à 200 KGY.

4. Film de polyoléfine pré-réticulé par rayonnement pour encapsulation préparé par le procédé selon la revendication 1, dans lequel :
la partie réticulée d'un film de polyoléfine formée après l'irradiation par la source d'énergie de rayonnement a une épaisseur de 5 % à 100 % de l'épaisseur totale du film de polyoléfine,
que la partie pré-réticulée a une épaisseur de 100 % par rapport à l'épaisseur totale du film de polyoléfine signifie que le film de polyoléfine est entièrement pré-réticulé, et
la partie pré-réticulée a un degré de réticulation de 3 % à 95 %, éventuellement, la partie réticulée dans le film de polyoléfine est une couche superficielle du film de polyoléfine.

5. Film de polyoléfine préréticulée par rayonnement pour encapsulation selon la revendication 4, dans lequel :
le film de polyoléfine est un film de résine éthylène-acétate de vinyle (EVA), de préférence, le film de résine EVA comprend :
une résine EVA de 51 parties à 99,58 parties en poids, de préférence, le film de résine EVA contient un VA de 20 % à 35 % en poids,
des agents de réticulation de peroxyde organique de 0,3 partie à 2 parties en poids, de préférence, les agents de réticulation de peroxyde organique comprennent un ou plusieurs peroxydes de dialkyle, peroxydes d'alkylaryle, peroxydes de diaryle, peroxydes d'hydrogène, peroxydes de diacyl, peroxyesters, peroxyde de cétone, peroxycarbonate, et peroxycétals,
des agents de réticulation auxiliaires de 0,01 partie à 5 parties en poids, de préférence, les agents de réticulation auxiliaires comprennent un ou plusieurs des composés acryliques, méthacryliques, acrylamides, allyles et époxy,
des antioxydants de 0,1 partie à 2 parties en poids, de préférence, les antioxydants comprennent un ou plusieurs stabilisants à la lumière, absorbeurs d'UV et décomposeurs de vieillissement oxydatif thermique,
des agents de couplage au silane de 0,01 partie à 2 parties en poids, de préférence, l'agent de couplage au silane comprend un composé organique du silicium qui contient deux groupes chimiques ayant des propriétés chimiques différentes,
pigments de 0 partie à 40 parties en poids, de préférence, les pigments sont des additifs capables de changer une couleur du film de résine EVA, et les pigments comprennent un ou plusieurs des noirs de carbone, du lithopone, du sulfure de zinc, du dioxyde de titane et des billes de verre, et
un élastomère de polyoléfine de 0 partie à 40 parties en poids, éventuellement, l'élastomère de polyoléfine comprend une résine à chaîne carbone-carbone qui est mélangée avec de l'EVA, et l'élastomère de polyoléfine comprend un ou plusieurs parmi un polyéthylène basse densité, un copolymère d'éthylène et le butane et un copolymère d'éthylène et d'octane ; et
dans lequel : lorsque le film est entièrement pré-réticulé, le degré de réticulation du film de résine EVA est de 5 % à 74 % ;
facultativement, le film de résine EVA pré-réticulé par rayonnement comprend une couche unique, des doubles couches ou des couches multiples qui sont co-extrudées, et le film de résine EVA pré-réticulé par rayonnement a une épaisseur de 0,01 mm à 2 mm.

6. Film de polyoléfine préréticulée par rayonnement pour encapsulation selon la revendication 4, dans lequel :
le film de polyoléfine est un film d'élastomère de polyoléfine, de préférence, le film d'élastomère de polyoléfine comprend :
un élastomère polyoléfinique de 69 parties à 99,8 parties en poids,
des agents de réticulation auxiliaires de 0,01 partie à 5 parties en poids, de préférence, l'agent de réticulation auxiliaire comprend un ou plusieurs parmi l'isocyanurate de triallyle, le triallyle d'acide cyanurique, le triacrylate de triméthylol propane et le triméthacrylate de triméthylol propane,
antioxydants de 0,01 partie à 2 parties en poids, de préférence, les antioxydants comprennent un ou plusieurs antioxydants phénoliques, antioxydants à aminé encombrée, acides phosphoreux, benzophénone et benzotriazoles comprenant le tétra[β-(3,5-di-tert-butyl-4 l'ester de pentaérythritol de l'acide -hydroxyphényl)propionique, le sébaçate de (2,2,6,6-tétraméthyl-4-pipéridyle), la N,N'-di-sec-butyl-p-phénylènediamine, et une combinaison de ceux-ci,
des agents de couplage silane de 0 partie à 2 parties en poids, de préférence, l'agent de couplage silane comprend un composé organique du silicium qui contient deux groupes chimiques ayant des propriétés chimiques différentes,
agents de réticulation de peroxyde organique de 0 partie à 2 parties en poids, de préférence, les agents de réticulation de peroxyde organique comprennent des agents de réticulation de peroxyde organique de réticulation thermique utilisés pour les plastiques, et plus préférablement, les agents de réticulation de peroxyde organique comprennent un ou plusieurs peroxyde de dicumyle, t- le carbonate de butyle peroxy-2-éthylhexyle et le 2,5-diméthyl-2,5-bis(t-butylperoxy)hexane, et
pigments de 0 partie à 20 parties en poids, éventuellement, les pigments sont des additifs capables de changer une couleur du film de résine EVA, et de préférence, les pigments comprennent un ou plusieurs des noirs de carbone, lithopone, sulfure de zinc, dioxyde de titane et verre perles,
où:
l'élastomère polyoléfinique comprend un ou plusieurs copolymères d'éthylène avec un ou plusieurs parmi le butène, le pentène, l'hexane et l'octane, et
lorsque le film est entièrement pré-réticulé, le degré de réticulation du film élastomère de polyoléfine est de 3 % à 70 %.

7. Film de polyoléfine préréticulée par rayonnement pour encapsulation selon la revendication 6, dans lequel :
le film élastomère de polyoléfine préréticulé a une épaisseur de 0,2 mm à 1 mm.

8. Film de polyoléfine pré-réticulé par rayonnement pour encapsulation selon la revendication 6 ou 7, dans lequel :
l'élastomère polyoléfinique est greffé par un groupement polaire, ou
l'élastomère polyoléfinique et le groupement polaire ne sont pas greffés, et
lors de la formation du film, un additif de petite molécule avec le groupe polaire est ajouté.

9. Procédé d'encapsulation utilisant un film de polyoléfine pré-réticulé par rayonnement, comprenant :
préparer un film après avoir mélangé ensemble des matières premières polyoléfiniques, facultativement, l'étape de préparation du film après avoir mélangé les matières premières polyoléfiniques ensemble comprend : ;
utiliser une source d'énergie de rayonnement pour irradier le film, dans lequel la source d'énergie de rayonnement stimule directement une réaction de réticulation des matières premières polyoléfiniques, de préférence, la source d'énergie de rayonnement comprend un ou plusieurs des rayons β, des rayons y, des rayons X, des rayons a, et rayons neutroniques;
ajuster un dosage d'irradiation de la source d'énergie de rayonnement, de telle sorte qu'un degré de réticulation d'une partie pré-réticulée du film atteigne 3 % à 95 %, éventuellement, l'irradiation de la source d'énergie de rayonnement est effectuée sur une bobine du film de polyoléfine ou sur un film de polyoléfine expansé ;
ajuster le dosage d'irradiation de la source d'énergie de rayonnement, de telle sorte que la partie pré-réticulée du film a une épaisseur de 5 % à 100 % par une épaisseur totale du film, dans lequel : la partie pré-réticulée a une épaisseur de 100 % de l'épaisseur totale du film signifie que le film est entièrement pré-réticulé,
placer le film entre une couche protectrice avant et un substrat d'encapsulation, et former un ensemble d'encapsulation avec un corps encapsulé, dans lequel la partie pré-réticulée du film est en contact avec le corps encapsulé ; et
chauffer le module d'encapsulation pour réticuler davantage le film pour terminer l'encapsulation,
éventuellement, la partie pré-réticulée dans le film comprend au moins une couche superficielle du film,
facultativement, une température pour former le film est de 70 °C à 200 °C, et une température de moule est de 70 °C à 200 °C.

10. Module d'encapsulation formé par le procédé d'encapsulation utilisant le film de polyoléfine pré-réticulé par rayonnement selon la revendication 9, dans lequel :
le film de polyoléfine est placé entre la couche de protection avant et le substrat d'encapsulation, de préférence, le substrat d'encapsulation est en verre, en céramique ou en plastique,
le film de polyoléfine et le corps encapsulé sont inclus dans le module d'encapsulation, et
la partie préréticulée du film de polyoléfine est en contact avec le corps encapsulé.

11. Module d'encapsulation selon la revendication 10, dans lequel :
le corps encapsulé comprend un ou plusieurs éléments parmi une cellule solaire en silicium cristallin, une diode électroluminescente (DEL), une diode électroluminescente organique (OLED) et un dispositif d'affichage.

12. Module d'encapsulation selon la revendication 10, dans lequel :
le film comprend deux couches placées entre la couche de protection avant et le substrat d'encapsulation,
au moins l'une des deux couches est le film pré-réticulé, et
le corps encapsulé est placé entre les deux couches.

13. Module d'encapsulation selon la revendication 10, dans lequel :
la couche protectrice avant est une couche protectrice transparente comprenant un verre transparent, une céramique transparente ou un plastique transparent.

14. Module d'encapsulation selon la revendication 10, dans lequel :
le film comprend une couche de film éthylène-acétate de vinyle (EVA) et une couche de film EVA pré-réticulé, et
la couche du film EVA est placée adjacente à la couche de protection avant.

15. Module d'encapsulation selon la revendication 12, dans lequel chacune des deux couches est un film d'élastomère de polyoléfine (POE) pré-réticulé.
